# EUROPÄISCHE PATENTSCHRIFT

(11) **EP 3 496 341 B1**
(45) Veröffentlichungstag und Bekanntmachung des Hinweises auf die Patenterteilung: **04.11.2020**
(21) Anmeldenummer: 18196942.9
(22) Anmeldetag: 26.09.2018
(51) Int. Cl.: H04L 12/40, H04L 12/403, G06F 13/42, H04L 29/12

(54) **VERFAHREN ZUR STEUERUNG EINES SERIELLEN DATENBUSSYSTEMS UND BUSKNOTEN FÜR EIN DERARTIGES DATENBUSSYSTEM**
METHOD FOR CONTROLLING A SERIAL DATA BUS SYSTEM AND BUS NODES FOR SUCH A DATA BUSY SYSTEM
PROCÉDÉ DE COMMANDE D'UN SYSTÈME DE BASE DE DONNÉES SÉRIE ET NOEUDS DE BUS POUR UN TEL SYSTÈME DE BASE DE DONNÉES

(30) Priorität: 05.12.2017 DE 102017128923; 28.12.2017 EP 17210861
(43) Veröffentlichungstag der Anmeldung: 12.06.2019
(73) Patentinhaber: Elmos Semiconductor SE, 44227 Dortmund (DE)
(72) Erfinder: Schmitz, Christian, 44227 Dortmund (DE); Burchard, Bernd, 45276 Essen (DE)
(74) Vertreter: dompatent von Kreisler Selting Werner - Partnerschaft von Patent- und Rechtsanwälten mbB

(56) Entgegenhaltungen:
- EP-A2- 2 654 246
- DE-A1- 19 647 668
- DE-A1-102008 044 777

## Beschreibung

### Einleitung

Die Erfindung betrifft ein Verfahren zur Steuerung eines seriellen Datenbussystems und Busknoten für ein derartiges Datenbussystem.

Die Erfindung betrifft allgemein selbsttestfähige serielle Datenbussysteme und Verfahren zur Vergabe von Busknotenadressen innerhalb dieses seriellen Datenbusses mit einer Kette von Busknoten bzw. im Zusammenhang mit der Vorbereitung der Adressierung der Busknoten stehende Verfahren und Vorrichtungen.

### Allgemeine Einleitung und Stand der Technik

Aus dem Stand der Technik sind verschiedene Verfahren zur Adresszuweisung in LIN-Bus-Systemen bekannt. Hier sei beispielhaft auf die Schriften DE-B-10 2010 026 431, DE-B-10 147 512, EP-B-1 490 772 und US-B-9 331 866 verwiesen.

Allen diesen Schriften ist gemeinsam, dass die Menge an durch den Busmaster adressierbaren Busknoten (nachfolgend als Adressier-Busknoten bezeichnet) begrenzt ist, da jeder Busknoten im Rahmen der Autoadressierung einen definierten Strom in den Bus einleitet. In den Ein-Draht-Datenbus sind dabei in jedem Adressier-Busknoten Shunt-Widerstände (Bus-Shunts) eingefügt, an denen diese Ströme auf ihrem Weg zum Busmaster, in dem während des Adressvergabevorgangs eine Stromsenke aktiv ist, einen Spannungsabfall hervorrufen. Die dem Busmaster am nächsten benachbarten Adressier-Busknoten registrieren dabei einen höheren Spannungsabfall als die vom Bus-Master weiter entfernt angeordneten Adressier-Busknoten. Die Spannung über den Bus-Shunt wird mit einem Schwellwert verglichen. Wird dieser überschritten, kann der betreffende Busknoten, an dessen Bus-Shunt diese Schwellwertüberschreitung stattfindet, davon ausgehen, dass er nicht der letzte Busknoten in der Kette der Adressier-Busknoten vom Busmaster aus gesehen ist. Er schaltet dann seine Stromquelle ab und wartet auf den nächsten Initialisierungsdurchlauf.

Derjenige Adressier-Busknoten, der der letzte Busknoten in der Busknotenkette vom Busmaster aus ist, schaltet seine Stromquelle nicht ab. Nach Ablauf einer vorgegebenen Initialisierungszeit, kann dieser Busknoten davon ausgehen, dass er der letzte zu adressierende Adressier-Busknoten in der Kette der Adressier-Busknoten ist. Er übernimmt dann die vom Busmaster übermittelte Busknotenadresse und nimmt an weiteren Initialisierungsdurchläufen nicht mehr teil, bis durch einen Rücksetzbefehl oder eine sonstige Rücksetzbedingung die erhaltene Busknotenadresse für ungültig erklärt wird.

Das Problem ist nun, dass zum Ersten der elektrische Widerstand des Bus-Shunts möglichst klein sein soll. Zum Zweiten sollen möglichst viele Adressier-Busknoten adressiert werden können. Zum Dritten muss das Adressierungssystem in der Lage sein, mit einem negativen Masseversatz arbeiten zu können. Zum Vierten muss der Pegel über dem Bus-Shunt maximiert werden, was einen möglichst großen Adressierungsstrom erfordert. Zum Fünften darf die Stromsumme, die durch den Busmaster während des Adressvergabeprozesses aufgenommen werden muss, einen vorgegebenen Wert, bei LIN-Bussen derzeit 40mA, nicht überschreiten.

Aus der DE-B-10 2010 026 431 ist ein Verfahren bekannt, bei dem die einzelnen Adressier-Busknoten nicht mit einem konstanten Adressierungsstrom wie in der DE-B-10 147 512 und der EP-B-1 490 772 arbeiten, sondern diesen Adressierungsstrom kontinuierlich oder treppenförmig bis zum Überschreiten der Schwellen bei den vorausgehenden Busknoten steigern. Dies hat mehrere Nachteile: Zum Ersten führt dies beim Vorhandensein von sehr vielen Adressier-Busknoten zu einer zeitlich sehr langen Anstiegszeit. Die Zeit für die Durchführung der Autoadressierung ist aber begrenzt. Daher ist es notwendig, diese Zeit bis zur Adressierung des vom Bus-Master am weitesten entfernten und noch nicht adressierten Adressier-Busknotens zu verkürzen. Die DE-B-10 2010 026 431 löst daher nicht vollständig das Problem, sehr viele Adressier-Busknoten adressieren und den Widerstandswert des Bus-Shunt-Widerstands ausreichend weit absenken zu können. Außerdem führt die in der DE-B-10 2010 026 431 offenbarte technische Lehre nicht zu einer Selbsttestfähigkeit.

Ein weiterer Nachteil der DE-B-10 2010 026 431 ist, dass aus Robustheitsgründen auch hier ein gewisser Pegelumfang freigehalten werden muss, um zu verhindern, dass es zur Überlastung des Masters oder zu Fehladressierungen kommt. Um die Bus-Shunt-Widerstände zu minimieren und Konformität mit dem LIN-Bus herzustellen, ist es daher sinnvoll, den Gleichanteil im Adressierungsstrom zu maximieren. Bei der in der DE-B-10 2010 026 431 offenbarten technischen Lehre schwankt dieser Wert jedoch um einen Adressierungsstrompegelwert. Hierdurch wird der zur Verfügung stehende Adressierungsstrompegel unnötig reduziert.

Aus DE-B-10 256 631, EP-B-1 603 282, US-B-7 590 140, EP-B-1 490 772 und EP-B-1 298 851 sind Busknotenadressierungsverfahren bekannt, die einen Bus-Shunt-Widerstand (R2) innerhalb jedes Autoadressier-Busknotens (SL1, SL2, SL3) erfordern. Dieser Widerstand hat den Nachteil, dass er das EMV-Verhalten gegenüber einem standardkonformen LIN-Busknoten verschlechtert.

In DE-A-196 47 668, DE-A-10 2008 044 777 und EP-A-2 654 246 sind Bussysteme beschrieben, bei denen sich in der Busleitung Shunt-Widerstände befinden.

### Aufgabe

Der Erfindung liegt daher die Aufgabe zugrunde, eine Lösung zu schaffen, die die obigen Nachteile des Stands der Technik nicht aufweist und weitere Vorteile aufweist.

### Lösung der Aufgabe

Die Erfindung betrifft ein Verfahren zum Steuern eines seriellen Datenbussystems entsprechend dem Anspruch 1, und ein adressierbarer Busknoten entsprechend dem Anspruch 4.

Autoadressierverfahren für insbesondere serielle Datenbussysteme machen es erforderlich, dass in den Bus ein Strommessmittel (im Regelfall als Shunt-Widerstand ausgebildet) geschaltet ist, und zwar erfolgt dies für jeden adressierbaren Adressier-Busknoten (siehe beispielsweise EP-B-1 490 772, EP-A-2 571 200 und EP-A-2 654 246). Die Strommessmittel werden lediglich während der Adressierphase benötigt. Vorteilhaft ist es also, wenn diese Strommessmittel beim normalen Betrieb des Datenbussystems nicht mehr wirksam wären.

Mit "Busleitung" wird im Sinne der Erfindung sowohl ein Eindrahtbus als auch ein Zweidrahtbus verstanden, wobei letzterer differentiell ausgebildet und betrieben sein kann. Als "Busknoten" wird die Verbindungs-Hardware eines Busteilnehmers verstanden, über die der Busteilnehmer an die Busleitung angeschlossen ist. Ein Busknoten umfasst also beispielsweise auch einen Bus-Transceiver, vor allem aber den im Regelfall vorhandenen Pull-Up-Widerstand, der als Ruhestromquelle aufgefasst werden kann, und ggf. beispielsweise auch die Schalter (gegebenenfalls mit Ansteuerung), mit denen ein Busteilnehmer den Bus auf Masse legen kann. Sofern es sich bei einem Busknoten nicht um einen Standard-Busknoten sondern um einen adressierbaren Adressier-Busknoten handelt, gehört zum Busknoten im Rahmen der Erfindung auch noch die Hardware zum Einspeisen eines Adressierungsstroms mit zugehöriger Strommesseinheit und -detektion, wie weiter unten noch beschrieben werden wird.

Die Erfindung gemäß diesem Aspekt betrifft ein Verfahren zur Steuerung eines seriellen Datenbussystems, wobei bei diesem Verfahren
- in der Adressierphase jedem Adressier-Busknoten bei geöffnetem Überbrückungsschalter eine Adresse zugewiesen wird und
- in der Betriebsphase das Strommessmittel jedes adressierten Adressier-Busknotens durch Schließen des Überbrückungsschalters überbrückt wird.

Erfindungsgemäß ist also pro Strommessmittel ein Überbrückungsschalter vorgesehen, der wie das Strommessmittel vorteilhafter zum Adressier-Busknoten gehört und von diesem in Abhängigkeit davon, ob der betreffende Adressier-Busknoten bereits mit einer Adresse versehen ist oder nicht, angesteuert wird. Bei einem noch nicht adressierten Adressier-Busknoten ist der Überbrückungsschalter offen. Bereits adressierte Adressier-Busknoten steuern den Überbrückungsschalter derart an, dass dieser nun geschlossen ist und damit das Strommessmittel überbrückt wird.

In einer ersten Ausprägung der Erfindung kann vorgesehen sein, dass die Adressierphase mehrere Adressierzyklen aufweist, wobei pro Adressierzyklus jeweils einem der nicht bzw. noch nicht adressierten Adressier-Busknoten eine Adresse zugewiesen wird, und dass ein in einem Adressierzyklus adressierter Adressier-Busknoten von da ab an der weiteren Adressiervergabe für andere noch nicht adressierter Adressier-Busteilnehmer nicht mehr teilnimmt, wobei das in der Adressierphase einem bereits andressierten Adressier-Busknoten zugeordnete Strommessmittel durch Schließen des zu dem Strommessmittel parallel geschalteten Überbrückungsschalters überbrückt wird.

Erfindungsgemäß ist es also möglich, den Überbrückungsschalter zu schließen, sobald ein Adressier-Busknoten seine Adresse erhalten hat. Wenn also in einer Adressierphase mehrere zu adressierende Adressier-Busknoten mit Adressen zu versehen sind und damit in der Adressierphase mehrere Adressierzyklen zu durchlaufen sind, kann nach jedem Adressierzyklus einer der noch offenen Überbrückungsschalter geschlossen werden. Alternativ ist es möglich, die einzelnen Strommessmittel erst nach Abschluss der Adressierphase sämtlich jeweils zu überbrücken bzw. kurzzuschließen. Während der Adressierphase sind also sämtliche Strommessmittel "aktiv", was insoweit von Vorteil ist, als dann auf der Busleitung während der Adressierphase stets die gleichen "Verhältnisse" existieren, nämlich stets alle Strommessmittel in die Busleitung geschaltet sind.

In weiterer zweckmäßiger Ausgestaltung der Erfindung kann vorgesehen sein, dass in der Adressierphase jeder nicht oder noch nicht adressierte Adressier-Busknoten in die Busleitung einen zum Busmaster fließenden Adressierstrom einspeist, der durch das Strommessmittel des betreffenden nicht oder noch nicht adressierten Adressier-Busknotens fließt.

Bei dem zuvor beschriebenen Aspekt der Erfindung umfasst diese auch einen Adressier-Busknoten für ein serielles Datenbussystem mit einem an eine Busleitung angeschlossenen Busmaster und mit mehreren aufeinanderfolgend an die Busleitung angeschlossenen Busknoten, von denen einige Adressier-Busknoten sind und andere als Standard-Busknoten mit bereits festgelegter Adresse ausgeführt sein können, wobei der Adressier-Busknoten zur Zuweisung seiner Adresse durch den Busmaster vorgesehen ist und aufweist
- ein in die Busleitung schaltbares Strommessmittel,
- einen Überbrückungsschalter, der parallel zu dem Strommessmittel geschaltet ist,
- eine Adressierungsstromquelle zum Einspeisen eines zum Busmaster fließenden Adressierungsstroms in die Busleitung und
- eine Ansteuereinheit zur Ansteuerung des Überbrückungsschalters,
   wobei die Ansteuereinheit den Überbrückungsschalter in einer Adressierphase des Datenbussystems zur Vergabe einer Adresse zur Einnahme des geöffneten Zustands ansteuert und in einer nach Abschluss der Adressierphase erfolgenden Betriebsphase des Datenbussystems zur Einnahme des geschlossenen Zustands ansteuert.

Eine Alternative des erfindungsgemäßen Adressier-Busknotens kann darin gesehen werden, dass das Strommessmittel u.a. den von der Adressierungsstromquelle in die Busleitung eingespeisten Adressierungsstrom erfasst. Ein derartiger Adressier-Busknoten eignet sich also beispielsweise für ein Adressierverfahren, bei dem der Adressierungsstrom, den jeder Adressier-Busknoten, der noch nicht adressiert ist, in die Busleitung einspeist, sogleich mit erfasst wird. Der in Höhe des Adressier-Busknotens auf der Busleitung fließende Strom enthält also als einen Anteil auch den von dem betreffenden Adressier-Busknoten eingespeisten Adressierungsstrom. Auf ein derartiges Adressierungsverfahren wird weiter unten noch näher eingegangen werden.

Die Erfindung schlägt ferner ein Verfahren zur Vergabe von Adressen in einem seriellen Datenbussystem vor, wobei das Datenbussystem einen Busmaster und Busknoten aufweist und wobei einerseits der Busmaster an die Busleitung angeschlossen ist und andererseits die Busknoten aufeinanderfolgend an die Busleitung angeschlossen sind. Zumindest einige der Busknoten speisen in die Busleitung jeweils einen zum Busmaster fließenden Strom ein. einer der Busknoten ist der am nächsten zum Busmaster an die Busleitung angeschlossene erste Busknoten, während die anderen Busknoten stromauf des ersten Busknotens an die Busleitung angeschlossen sind. Anders ausgedrückt ist also einer der Busknoten der am weitesten entfernt vom Busmaster an die Busleitung angeschlossene letzte Busknoten, während die anderen Busknoten stromab dieses letzten Busknotens zwischen diesem Busknoten und dem Busmaster an die Busleitung angeschlossen sind. Zumindest zwei der Busknoten sind Adressier-Busknoten, denen vom Busmaster in einer Adressierphase jeweils eine Adresse zugeordnet wird, während weitere Busknoten Standard-Busknoten mit jeweils bereits vor der Durchführung der Adressierphase festgelegter Adresse sein können.

Die Motivation für eine verbesserte Autoadressierung bei einem seriellen Datenbussystem wie beispielsweise bei einem LIN-Bus soll nachfolgend nochmals kurz erläutert werden, und zwar am Beispiel eines LIN-Busses.

Der Busstrom während des Betriebs eines LIN-Busses muss unterhalb eines Maximalwerts liegen. Wird dieser Wert überschritten, deutet das auf einen Kurzschluss des Busses nach Masse hin, was erkannt werden muss.

Während des normalen Betriebs eines LIN-Busses fließt in diesem ein sogenannter Grundstrom. Dieser Grundstrom dient z.B. der Stabilität des Busses und macht diesen unempfindlicher gegenüber z.B. elektromagnetischen Störeinflüssen.

Bei der Autoadressierung der LIN-Busknoten speisen diese einen Adressierungsstrom ein. Je nachdem, wie viele zu adressierende Busknoten am Bus angeschlossen sind, würde bei Einspeisung der Adressierungsströme durch sämtliche Busknoten die Bus-Maximalstrombelastung überschritten. Damit wäre die Autoadressierung nicht möglich.

Daher ist man bei LIN-Bus-Anwendungen in der Vergangenheit dazu übergegangen, eine sogenannte Preselect-Phase zwischenzuschieben, in der nicht sämtliche Busknoten adressiert werden, sondern nur eine Gruppe von Busknoten, wobei die Größe der Gruppe so gewählt ist, dass bei Einspeisung der Adressierungsströme sämtlicher Busknoten dieser Gruppe die Maximalstrombelastung des Bus nicht überschritten wird.

Nachteilig bei der LIN-Anwendung sind die Shunt-Widerstände im Bus. Man ist bestrebt, diese Widerstände so klein wie möglich zu wählen, um beispielsweise Verluste zu minimieren oder andere Netzwerkprobleme zu vermeiden.

Wenn nun aber die Widerstände kleiner dimensioniert werden, verringert sich auch der Spannungsabfall, also das Messsignal, das dann wiederum verstärkt werden muss. Dies ist mit zusätzlicher Hardware verbunden.

Um das Messsignal zu vergrößern, und zwar ohne Verstärkung, geht man dazu über, den Adressierungsstrom zu erhöhen. Dann besteht umso mehr die Gefahr, bei der Autoadressierung in die Maximalstrombegrenzung des Busses zu kommen.

Erfindungsgemäß weisen die adressierbaren Teilnehmer einen Busknoten mit einem Transceiver auf, also mit einer mit der Busleitung verbundenen Hardware auf, die zusätzlich mit einer Einheit zum Einprägen eines Adressierungsstroms und zum Messen von Adressierungsströmen auf der Busleitung versehen sind. Vom Busmaster aus betrachtet befindet sich die Stromeinspeisung in der Busleitung hinter dem Shunt-Widerstand, der ebenfalls auf der Busleitung liegt.

Es wird davon ausgegangen, dass das Bus-System einen Misch-Verbau von Adressier-Busknoten und nicht adressierbaren Standard-Busknoten aufweist. Die Standard-Busknoten haben feste Adressen und nehmen an dem Autoadressiervorgang nicht teil. Alle Busknoten, also sowohl die Standard-Busknoten als auch die Adressier-Busknoten, prägen zur Stabilisierung der Busleitung und zur gleichmäßigen Buspotentialerzeugung über die Länge der Busleitung betrachtet Ruheströme in die Busleitung ein oder können solche Ruheströme einspeisen. Nicht jeder Standard- und/oder Adressier-Busknoten muss diesen Busstrom zwangsweise einspeisen während der Autoadressierphase. Jeder Adressier-Busknoten erfasst zunächst den Grundstrom als Summe aller von den Standard- und Adressier-Busknoten hinter ihm eingespeisten Ruheströme. Vorgegeben wird nun ein Maximal-Busstrom, der um ein gewisses Maß unterhalb desjenigen Stromwerts liegt, bei dem der Busmaster einen Fehlerfall (beispielsweise Buskurzschluss) erkennen würde und den Bus nach Masse ziehen würde.

Die Adressier-Busknoten speisen nun sämtlich jeweils einen Adressierungsstrom ein, der aber nicht schlagartig eingespeist wird. Der vom Busmaster aus betrachtet am weitesten entfernt liegende Busknoten misst dabei "seinen" eigenen Adressierstrom sowie weitere Ströme, die von denjenigen Busknoten einspeisbar sind, die weiter entfernt vom Busmaster als der betrachtete Busknoten der Busleitung verbunden ist.

Beim langsamen Hochfahren des Adressierungsstroms sämtlicher noch nicht adressierter Adressier-Busknoten erkennt also einer der zum Busmaster näher liegenden Adressier-Busknoten, dass der vorgegebene Maximal-Busstrom erreicht wird. Daraufhin fährt dieser Adressier-Busknoten seine Adressierungsstromquelle zurück, und zwar vorzugsweise schneller als er sie zuvor hochgefahren hat. Die anderen noch nicht adressierten Adressier-Busknoten fahren ihre Adressierungsstromquellen weiterhin hoch, bis dann ein weiterer näher am Busmaster liegender Adressier-Busknoten erkennt, dass der Maximal-Busstrom erreicht werden könnte. Dann fährt auch dieser Adressier-Busknoten seine Adressierungsstromquelle herunter.

Dies führt zu einer "Kettenreaktion", bis dann am Ende ausschließlich der letzte, d.h. der am weitesten vom Busmaster entfernt angeordnete noch nicht adressierte Adressier-Busknoten seine Adressierungsstromquelle soweit hochgefahren hat, bis der Maximal-Busstrom von ihm selbst gemessen wird. Damit "weiß" dieser Adressier-Busknoten, dass er jetzt identifiziert ist. Denn nach Beendigung eines Adressierzyklus ist er der einzige, dessen Adressierungsstromquelle einen Adressierungsstrom liefert. Würde jetzt eine Adresse auf die Busleitung gelegt, so würde dieser Adressier-Busknoten die Adresse als die seinige annehmen können. Alternativ kann zuvor vom Busmaster aus an sämtliche noch nicht adressierte Adressier-Busknoten eine Adresse verschickt worden sein, so dass nun der eine besagte Adressier-Busknoten diese Adresse als die seinige annimmt und die anderen der noch nicht adressierten Adressier-Busknoten die Busadresse verwerfen.

Das zuvor beschriebene Verfahren funktioniert beim Misch-Verbau dann besonders vorteilhaft, wenn sich die Standard-Busknoten ausschließlich hinter dem am weitesten vom Busmaster entfernt angeordneten Adressier-Busknoten befinden. Denn dann können die Adressier-Busknoten die Summe der von diesen Standard-Busknoten eingespeisten Ruheströme als Summenruhestrom erfassen. Sind die Standard-Busknoten zwischen dem Busmaster und dem ersten Adressier-Busknoten angeordnet, so weiß dieser Adressier-Busknoten sowie die weiteren dahinter angeordneten Adressier-Busknoten nicht, wie groß der sich aus den Ruheströmen zusammensetzende Grundstrom ist, da sie keinen Ruhestrom der Standard-Busknoten messen können. Dem könnte entgegengewirkt werden, indem jeder Adressier-Busknoten eine Information darüber erhält, wie viele Standard-Busknoten sich zwischen der Gruppe der Adressier-Busknoten und dem Busmaster befinden.

Ein Misch-Verbau dergestalt, dass wechselweise Standard-Busknoten und Adressier-Busknoten aufeinanderfolgen, könnte hingegen tolerierbar sein. Sollte nämlich dann der letzte, am weitesten vom Busmaster entfernt angeordnete Busknoten ein Adressier-Busknoten sein, so müsste nur dieser eine Busknoten eine Information erhalten, wie viele Standard-Busknoten vor ihm an die Busleitung angeschlossen sind.

Das erfindungsgemäße Verfahren dient der Vergabe von Adressen für die Adressier-Busknoten, wobei bei dem Verfahren
- die Busknoten einen Ruhestrom in die Busleitung einspeisen oder potentiell einen Ruhestrom in die Busleitung einspeisen oder - alternativ - einige der Standard-Busknoten und/oder einige der Adressier-Busknoten einen Ruhestrom in die Busleitung einspeisen und andere der Standard-Busknoten und/oder der Adressier-Busknoten keinen Ruhestrom in die Busleitung einspeisen,
- jeder noch nicht adressierte Adressier-Busknoten in die Busleitung einen Adressierungsstrom einspeist,
- jeder noch nicht adressierte Adressier-Busknoten mit Hilfe eines Strommessmittels den ihn durchfließenden Busstrom als Summe der Ruheströme sämtlicher stromauf angeordneter Busknoten (d.h. Ruheströme sowohl der Adressier-Busknoten bzw. der jeweils noch nicht adressierten adressier-Busknoten und der Standard-Busknoten, die gegebenenfalls auch jeweils einen Ruhestrom in die Busleitung einspeisen) und seines eigenen Adressierungsstroms und der Adressierungsströme sämtlicher stromauf angeordneter, noch nicht adressierter Adressier-Busknoten detektiert,
- ein während der Adressierphase maximal zulässiger Maximal-Adressierungsstrom bestimmt wird, der zusammen mit der Summe aus sämtlichen eingespeisten Ruheströmen einen maximal zulässigen Maximal-Busstrom ergibt, welcher kleiner ist als derjenige in den Busmaster fließende Busstrom, bei dem im Bus-master ein z.B. Buskurzschluss-Fehlerfall erkannt wird (anders ausgedrückt wird also der Maximal-Adressierungsstrom bestimmt als Differenz desjenigen in den Busmaster fließenden Busstroms, bei dem ein (z.B. Busleitungskurzschluss-)Fehlerfall erkannt wird, und der Summe aus den Ruheströmen sämtlicher jeweils einen Ruhestrom in die Busleitung einspeisender Busknoten, bei denen es sich um Standard-Busknoten und/oder Adressier-Busknoten handeln kann),
- in der Adressierphase mehrere jeweils für eine vorgebbare Zeitdauer andauernde Adressierzyklen zur Identifikation jeweils eines noch nicht adressierten Adressier-Busknotens durchgeführt werden, wobei ein in einem Adressierzyklus identifizierter Adressier-Busknoten an dem nachfolgenden Adressiervorgang nicht mehr teilnimmt, indem er sich z.B. wie ein Standard-Busknoten verhält,
- pro Adressierzyklus
   - zu Beginn jeder noch nicht adressierte Adressier-Busknoten einen mit einer Anstiegsrate größer werdenden Adressierungsstrom in die Busleitung einspeist,
   - während der Adressierphase jeder noch nicht adressierte Adressier-Busknoten den ihn durchfließenden Busstrom misst, sowie mit dem Maximal-Busstrom vergleicht und beim Überschreiten des Maximal-Busstroms seinen in die Busleitung eingespeisten Adressierungsstrom mit einer Verringerungsrate verringert oder jeder noch nicht adressierte Adressier-Busknoten seinen in die Busleitung eingespeisten Adressierungsstrom misst sowie mit dem Maximal-Adressierungsstrom vergleicht und beim Überschreiten des Maximal-Adressierungsstroms seinen in die Busleitung eingespeisten Adressierungsstrom mit einer Verringerungsrate verringert, und
   - am Ende des Adressierzyklus ein einziger noch nicht adressierter Adressier-Busknoten verbleibt, der den Maximal-Adressierungsstrom in die Busleitung einspeist und damit identifiziert ist, und
- diesem identifizierten Adressier-Busknoten eine Adresse zugewiesen wird.

Nach der Erfindung erfasst jeder noch nicht adressierte Adressier-Busknoten seinen eigenen in die Busleitung eingespeisten Adressierungsstrom. Jeder Adressier-Busknoten kennt den maximal zulässigen Maximal-Adressierungsstrom. Die zum Busmaster nächst gelegen Adressier-Busknoten werden während der Adressierphase bzw. während eines Adressierzyklus größere Summenströme auf der Busleitung detektieren, als diejenigen Adressier-Busknoten, die weiter entfernt vom Busmaster an die Busleitung angeschlossen und noch adressiert sind. Wenn nun sämtliche noch nicht adressierten Adressier-Busknoten jeweils einen ansteigenden Busstrom in die Busleitung einspeisen, so wird einer der vorderen, d.h. näher am Busmaster gelegenen Adressier-Busknoten und insbesondere der erste noch nicht adressierte Adressier-Busknoten als erstes "merken", dass er den von ihm eingespeisten Adressierungsstrom reduzieren muss, damit der Maximal-Adressierungsstrom auf der Busleitung nicht erreicht oder gar überschritten wird. Der zum Busmaster nächst gelegene noch nicht adressierte Adressier-Busknoten fährt schließlich seinen Adressierungsstrom gegen null, und dieser Vorgang setzt sich über den nächsten noch nicht adressierten Adressier-Busknoten fort, bis schließlich nur noch ein noch nicht adressierte Adressier-Busknoten seinen vollen Adressierungsstrom in die Busleitung einspeist, ohne dass die Busleitung einen Busstrom führt, der größer als der Maximal-Adressierungsstrom ist. Am Ende eines Adressierzyklus existiert also nur noch ein einziger noch nicht adressierter Adressier-Busknoten, der sich in dem zuvor beschriebenen Betriebszustand befindet. Diesem Adressier-Busknoten, der nunmehr identifiziert ist, kann jetzt eine Adresse zugeordnet werden.

Ein wesentlicher Vorteil des erfindungsgemäßen Verfahrens besteht darin, dass zu Beginn einer Adressierphase feststeht, welchen Adressierungsstrom jeder noch nicht adressierte Adressier-Busknoten maximal einspeisen darf. Dieser Adressierungsstrom ist für sämtliche Adressier-Busknoten gleich. Der Vergleich des auf der Busleitung fließenden Stroms mit dem Maximal-Adressierungsstrom ist für jeden Adressier-Busknoten identisch, was das erfindungsgemäße Verfahren weiter vereinfacht.

In zweckmäßiger Ausgestaltung der Erfindung kann vorgesehen sein, dass so viele Adressierzyklen durchgeführt werden, wie zu adressierende Adressier-Busknoten an die Busleitung angeschlossen sind.

Eine Besonderheit kann dann gegeben sein, wenn nur noch einer der Adressier-Busknoten noch nicht adressiert ist. Dann nämlich kann entweder noch ein weiterer Adressierzyklus durchgeführt werden, an dessen Ende sich dann herausgestellt, dass exakt dieser eine noch nicht adressierte Adressier-Busknoten identifiziert ist und mit einer Adresse versehen werden kann. Es ist aber auch möglich, bei lediglich noch einem noch nicht adressierten Adressier-Busknoten keinen weiteren Adressierzyklus durchzuführen, so dass diesem letzten noch nicht adressierten Adressier-Busknoten seine Adresse von dem Busmaster zugewiesen wird, ohne dass dieser letzte noch nicht adressierte Adressier-Busknoten einen Adressierungsstrom in die Busleitung einspeist.

In weiterer vorteilhafter Ausgestaltung der Erfindung kann vorgesehen sein, dass die Zuweisung der Adresse zu dem in einem Adressierzyklus identifizierten Adressier-Busknoten durch vor oder zu Beginn des Adressierzyklus erfolgende Vergabe einer Adresse an sämtliche noch nicht adressierten Adressier-Busknoten oder durch Vergabe der Adresse am Ende eines Adressierzyklus erfolgt.

Wie bereits oben beschrieben, erfolgt in jedem noch nicht adressierten Adressier-Busknoten die Vergrößerung des Adressierungsstroms mit einer gewissen Anstiegsrate, während das Zurückfahren des Adressierungsstroms mit einer gewissen Verringerungsrate erfolgt. Grundsätzlich gilt, dass es zweckmäßig ist, die Verringerungsrate, mit der jeder noch nicht adressierte Adressier-Busknoten beim Überschreiten des Maximal-Busstroms oder des Maximal-Adressierungsstroms seinen in die Busleitung eingespeisten Adressierungsstrom verringert, größer gewählt wird als die Anstiegsrate, mit der jeder noch nicht adressierte Adressier-Busknoten seinen Adressierungsstrom bis zum Überschreiten in die Busleitung einspeist. Die Anstiegs- und die Verringerungsrate werden zweckmäßigerweise durch eine erste Zeitkontante (für die Anstiegsrate) und durch eine zweite Zeitkonstante (für die Verringerungsrate) definiert. Je kleiner die Zeitkonstante ist, desto größer ist die entsprechende Anstiegs- bzw. Verringerungsrate. Wenn während eines Adressierzyklus ein noch nicht adressierter Adressier-Busknoten merkt, dass er zur Einhaltung des Maximal-Adressierungsstroms auf der Busleitung seinen Adressierungsstrom zurückfahren muss, so sollte dies wesentlich schneller erfolgen als der weitere Anstieg der Adressierungsströme, die von den anderen noch nicht adressierten Adressier-Busknoten in die Busleitung eingespeist werden. Denn wenn einer der noch nicht adressierten Adressier-Busknoten seinen Adressierungsstrom zurückfährt, merken die anderen noch nicht adressierten Adressier-Busknoten davon möglicherweise noch nichts, weil sie auf Grund der Tatsache, dass sie andere Summenströme auf der Busleitung messen, einen Busstrom detektieren, der noch mehr oder weniger deutlich geringer als der Maximal-Adressierungsstrom ist. Damit speisen diese noch nicht adressierten Adressier-Busknoten weiterhin ihren Adressierungsstrom ein, bis auch der erste von diesen anderen noch nicht adressierten Adressier-Busknoten merkt, dass die Maximal-Adressierungsstrombelastung erreicht wird, um dann als Folge davon ebenfalls seinen Adressierungsstrom zurückzufahren. Dieser ganze Prozess macht es zweckmäßig, das Zurückfahren eines Adressierungsstroms mit deutlich größerer Verringerungsrate durchzuführen, als das Ansteigenlassen der Adressierungsströme. Die zweite Zeitkonstante, also die Verringerungsrate, sollte zweckmäßigerweise um mindestens den Faktor 2 oder 5 oder 10 oder 20 oder 50 oder 100 oder 200 oder 500 oder 1000 kleiner sein als die erste Zeitkonstante, d.h. die Anstiegsrate.

Alternativ bzw. zusätzlich zu dem zuvor Gesagten kann die erste und/oder die zweite Zeitkonstante jeweils von der Größe des von einem noch nicht adressierten Adressier-Busknoten ermittelten Busstrom oder von der Größe des von einem noch nicht adressierten Adressier-Busknoten in den Adressier-Busknoten eingespeisten Adressierungsstrom abhängen oder abhängig gewählt werden.

In weiterer zweckmäßiger Ausgestaltung der Erfindung kann es von Vorteil sein, wenn die erste und/oder die zweite Zeitkonstante jeweils in Abhängigkeit davon, ob der von einem noch nicht adressierten Adressier-Busknoten ermittelte Busstrom oder der von einem noch nicht adressierten Adressier-Busknoten in die Busleitung eingespeiste Adressierungsstrom größer als ein oder gleich einem Schwellwert oder kleiner als der Schwellwert ist oder - alternativ - größer als ein Schwellwert oder kleiner als der oder gleich dem Schwellwert ist, unterschiedlich ist.

Bei der zuvor beschriebenen Alternative der Wahl der beiden Zeitkonstanten kann ferner vorgesehen sein, dass die erste Zeitkonstante ab dem oder oberhalb des Schwellwerts größer wird oder ist als bei dem oder unterhalb des Schwellwerts und/oder dass die zweite Zeitkonstante ab dem oder unterhalb des Schwellwerts kleiner wird oder ist als bei dem oder oberhalb des Schwellwerts.

Als Folge der zuvor beschriebenen Varianten für die Wahl der Zeitkonstanten und die Wahl der Größen der Verringerungs- und Anstiegsraten relativ zueinander stellt sich also heraus, dass der Maximal-Adressierungsstrom, der kleiner ist als der Maximal-Busstrom, umso größer gewählt wird, desto größer der Faktor ist, um den die zweite Zeitkonstante oder deren größter Wert kleiner ist als die erste Zeitkonstante oder deren größter Wert.

In weiterer zweckmäßiger Ausgestaltung der Erfindung kann zur Untersuchung, ob die Adressenvergabe korrekt abgelaufen ist, vorgesehen sein, am Ende des letzten Adressierzyklus, durch seitens des Busmasters erfolgende Abfrage zu überprüfen, ob zumindest ein noch nicht adressierter Adressier-Busknoten existiert.

Ferner kann zu dem zuvor genannten Zweck vorteilhafterweise vorgesehen sein, dass am Ende eines jeden Adressierzyklus oder am Ende zumindest einiger Adressierzyklen und bei Kenntnis der Anzahl der zu adressierenden Adressier-Busknoten insbesondere am Ende des letzten Adressierzyklus jeder noch nicht adressierte Adressier-Busknoten eine entsprechende Meldung über die bisher noch nicht erfolgte Adresszuweisung an den Busmaster sendet.

In einer weiteren Ausgestaltung der Erfindung können in der Adressierphase so viele Adressierzyklen durchgeführt werden, bis in einem Adressierzyklus insbesondere durch den Busmaster festgestellt wird, dass keiner der Adressier-Busknoten einen oder jedenfalls nicht den Maximal-Adressierungsstrom in die Busleitung einspeist.

Zur Reduzierung möglicher Fehler bei der Adressvergabe ist es weiterhin von Vorteil, wenn am Ende eines Adressierzyklus überprüft wird, ob ein zuvor noch nicht adressierter Adressier-Busknoten existiert, dem eine Adresse zuzuweisen ist, und/oder wenn am Ende eines Adressierzyklus überprüft wird, ob der für die Zuweisung einer Adresse identifizierte Adressier-Busknoten die zugewiesene Adresse angenommen hat.

Wenn alternativ die Anzahl der zu adressierenden Busknoten vor Beginn der Adressierphase und somit die Anzahl an durchzuführenden Adressierzyklen bekannt ist, kann nach Beendigung der Adressierphase überprüft werden, ob jedem Adressier-Busknoten eine Adresse zugeordnet worden ist.

In weiterer zweckmäßiger Ausgestaltung der Erfindung kann vorgesehen sein, dass die Identifikation des betreffenden noch nicht adressierten Adressier-Busknotens erfolgt, sobald innerhalb des Adressierzyklus und damit potentiell vor dem Ende der vorgegebenen Zeitdauer des Adressierzyklus festgestellt wird, dass einer der noch nicht adressierten Adressier-Busknoten den Maximal-Adressierungsstrom in die Busleitung einspeist. Dies hat den Vorteil, dass im Nachhinein während eines Adressierzyklus noch auftretende z.B. elektromagnetische Störeinflüsse sich auf den bereits abgeschlossenen Prozess der Identifizierung eines noch nicht adressierten Adressier-Busknotens nicht mehr auswirken kann.

Von Vorteil für die Durchführung des erfindungsgemäßen Verfahrens kann es sein, wenn sämtliche Standard-Busknoten mit bereits vor Durchführung der Adressierphase festgelegter Adresse stromauf sämtlicher Adressier-Busknoten an die Busleitung angeschlossen sind.

Alternativ ist es möglich, dass zumindest ein Standard-Busknoten mit bereits vor der Adressierphase festgelegter Adresse stromab eines Adressier-Busknotens an die Busleitung angeschlossen ist und dass dieser Adressier-Busknoten eine Information über die Anzahl der bezogen auf diesen Adressier-Busknoten stromab angeordneten Standard-Busknoten erhält und damit ein mögliches Maximum der Summe der von diesen Standard-Busknoten in die Busleitung eingespeisten Ruheströme kennt.

Mit der Erfindung wird ferner ein Adressier-Busknoten für ein serielles Datenbussystem mit einem an eine Busleitung angeschlossenen Busmaster und mit mehreren aufeinanderfolgend an die Busleitung angeschlossenen Busknoten vorgeschlagen, von denen einige Adressier-Busknoten sind und andere als Standard-Busknoten mit bereits festgelegter Adresse ausgeführt sein können, wobei der Adressier-Busknoten zur Zuweisung seiner Adresse durch den Busknoten vorgesehen ist und aufweist
- ein Strommessmittel,
- eine Adressierungsstromquelle zum Einspeisen eines Adressierungsstroms in die Busleitung und durch diese zum Busmaster und zwar bei Erfassung durch das Strommessmittel und
- eine Ruhestromquelle zum Einspeisen eines Ruhestroms in die Busleitung und durch diese zum Busmaster, wobei die Ruhestromquelle mit der Adressierungsstromquelle identisch sein kann, und
- eine Ansteuereinheit zur mit einer ggf. variablen Anstiegsrate erfolgenden Erhöhung des von der Adressierungsstromquelle gelieferten Adressierungsstroms bis zum potentiellen Überschreiten eines vorgebbaren Maximalstroms und zur mit einer ggf. variablen Verringerungsrate erfolgenden, und zwar insbesondere bis auf null erfolgenden Verringerung des von der Adressierungsstromquelle gelieferten Adressierungsstroms beim potentiellen, einmaligen Überschreiten des Maximalwerts.

In zweckmäßiger Ausgestaltung der Erfindung kann vorgesehen sein, dass das Strommessmittel den in die Busleitung einzuspeisenden Adressierungsstrom der Adressierungsstromquelle erfasst und die Ansteuereinheit den Adressierungsstrom mit einem vorgebbaren Maximal-Adressierungsstrom vergleicht.

In weiterer zweckmäßiger Ausgestaltung der Erfindung kann vorgesehen sein, dass das Strommessmittel in die Busleitung integrierbar ist und den Busstrom erfasst und dass die Ansteuereinheit den Busstrom mit einem vorgebbaren Maximal-Busstrom vergleicht.

Erfindungsgemäß kann vorgesehen sein, dass die Anstiegsrate durch eine erste Zeitkonstante und die Verringerungsrate durch eine zweite Zeitkonstante definiert ist und dass die zweite Zeitkonstante um mindestens den Faktor 2 oder 5 oder 10 oder 20 oder 50 oder 100 oder 200 oder 500 oder 1000 kleiner ist als die erste Zeitkonstante.

In zweckmäßiger Ausgestaltung der Erfindung kann vorgesehen sein, dass die erste und/oder die zweite Zeitkonstante jeweils in Abhängigkeit von der Größe des von einem noch nicht adressierten Adressier-Busknoten ermittelten Busstrom oder in Abhängigkeit von der Größe des von einem noch nicht adressierten Adressier-Busknoten in den Adressier-Busknoten eingespeisten Adressierungsstrom gewählt wird.

In weiterer zweckmäßiger Ausgestaltung der Erfindung kann vorgesehen sein, dass die erste und/oder die zweite Zeitkonstante jeweils in Abhängigkeit davon unterschiedlich ist, ob der von einem noch nicht adressierten Adressier-Busknoten ermittelte Busstrom oder der von einem noch nicht adressierten Adressier-Busknoten in die Busleitung eingespeiste Adressierungsstrom größer oder gleich einem Schwellwert oder kleiner als der Schwellwert oder alternativ größer als ein Schwellwert oder kleiner oder gleich dem Schwellwert ist.

Bei Autoadressierverfahren zur automatischen Vergabe von Adressen an Adressier-Busknoten eines seriellen Datenbussystems kann es von Vorteil sein, wenn jeder Adressier-Busknoten, dem eine Adresse zugewiesen wird, die Größe des an seinem Verbindungspunkt mit der Busleitung fließenden Busstroms messtechnisch erfassen kann, wobei dieser Verbindungspunkt-Busstrom auch durch den eigenen von dem betreffenden Adressier-Busknoten eingespeisten Adressierungsstrom beinhaltet. Das allerdings setzt voraus, dass beim Aufbau des seriellen Datenbussystems jeder Busknoten korrekt, d.h. in der richtigen "Orientierung" an die Busleitung angeschlossen ist.

Demzufolge befasst sich ein weiterer Aspekt der Erfindung mit einem Verfahren zum Einspeisen von Adressierungsströmen in die Busleitung eines seriellen Datenbussystems, und zwar über Adressier-Busknoten, wobei das Datenbussystem neben einem Busmaster und den Adressier-Busknoten sowie gegebenenfalls Standard-Busknoten eine Busleitung aufweist, an die einerseits der Busmaster angeschlossen ist und an die andererseits die Busknoten aufeinanderfolgend angeschlossen sind. Hierbei gilt im Rahmen der Erfindung, dass die Busleitung einen Eindrahtbus oder einen Zweidrahtbus aufweisen kann, der gegebenenfalls differentiell, d.h. mit differentiellen Signalen betrieben wird.

Ein Aspekt der Erfindung betrifft ein Verfahren zur Detektion der korrekten Einspeisung von Adressierungsströmen durch Busknoten eines seriellen Datenbussystems in dessen Busleitung, wobei bei dem Verfahren
- die Busknoten einen Ruhestrom in die Busleitung einspeisen oder potentiell einen Ruhestrom in die Busleitung einspeisen oder - alternativ - einige der Standard-Busknoten und/oder einige der Adressier-Busknoten einen Ruhestrom in die Busleitung einspeisen und andere der Standard-Busknoten und/oder der Adressier-Busknoten keinen Ruhestrom in die Busleitung einspeisen,
- jeder noch nicht adressierte Adressier-Busknoten in die Busleitung einen Adressierungsstrom einspeist,
- jeder noch nicht adressierte Adressier-Busknoten mit Hilfe eines Strommessmittels den ihn durchfließenden Busstrom als Summe der Ruheströme sämtlicher stromauf angeordneter Busknoten (d.h. Ruheströme sowohl der Adressier-Busknoten bzw. der jeweils noch nicht adressierten adressier-Busknoten und der Standard-Busknoten, die gegebenenfalls auch jeweils einen Ruhestrom in die Busleitung einspeisen) und seines eigenen Adressierungsstroms und der Adressierungsströme sämtlicher stromauf angeordneter, noch nicht adressierter Adressier-Busknoten detektiert,
- während einer Adressierphase durch Analyse von seitens noch nicht adressierter Adressier-Busknoten eingespeisten Adressierungsströmen einzelne dieser Busknoten identifiziert werden,
- ein noch nicht adressierter Adressier-Busknoten den Adressierungsstrom wahlweise an einem von zwei Knotenpunkten in die Busleitung einspeist, wobei das Strommessmittel zwischen den beiden Knotenpunkten angeordnet ist, und
- für einen oder in einem noch nicht adressierten Adressier-Busknoten derjenige Knotenpunkt für die Einspeisung des Adressierungsstroms gewählt wird, bei dem das Strommessmittel den Adressierungsstrom detektiert oder bei dem das Strommessmittel einen Teststrom detektiert, der zur Ermittlung desjenigen Knotenpunkts, bei dem das Strommessmittel den Teststrom detektiert, wahlweise in einen der oder aufeinanderfolgend in jeden der Knotenpunkte eingespeist wird.

Mit dem Verfahren wird also gemäß diesem Aspekt der Erfindung dafür gesorgt, dass unabhängig von einem Vertauschen der Ein- und Ausgänge eines Adressier-Busknotens, über die der Busknoten in den seriellen Datenbus eingebunden wird, die Einspeisung des Adressierungsstroms stets dergestalt erfolgt, dass dieser eingespeiste Adressierungsstrom, der in Richtung Busmaster fließt, in jedem Fall auch durch das Strommessmittel, das in die Busleitung geschaltet ist, fließt bzw. von dem Strommessmittel erfasst wird.

Gemäß einer ersten Variante der Erfindung weist jeder Adressier-Busknoten bzw. weisen zumindest einige der Adressier-Busknoten zwei Adressierungsstromquellen auf, die über jeweils einen Knotenpunkt mit der Busleitung in Wirkverbindung stehen. Zwischen den beiden Knotenpunkten befindet sich nun das Strommessmittel bzw. das Strommessmittel selbst steht in Wirkverbindung mit der Busleitung, und zwar mit demjenigen Abschnitt der Busleitung, der zwischen den beiden besagten Knotenpunkten liegt.

Vom Hardware-Aufwand vorteilhaft ist es, wenn, wie es gemäß einer weiteren Variante dieses Aspekts der Erfindung vorgesehen ist, jeder Adressier-Busknoten bzw. zumindest einige der Adressier-Busknoten eine einzige Adressierungsstromquelle aufweist/aufweisen. Bei dieser Variante der Erfindung gilt dann, dass
- der Adressierungsstrom in den Eingang einer Umschalteinheit fließt, die zwei Ausgänge aufweist, von denen der eine mit dem einen Knotenpunkt und der andere mit dem anderen Knotenpunkt in Wirkverbindung steht,
- die Umschalteinheit in einer ersten Schaltstellung, in der der Eingang der Umschalteinheit mit deren einen Ausgang verbunden ist, überführt oder in diese erste Schaltstellung voreingestellt wird,
- bei Einspeisung des Adressierungsstroms oder des Teststroms in dieser ersten Schaltstellung der Umschalteinheit überprüft wird, ob das Strommessmittel des Adressierungsstrom oder - alternativ - den Teststrom erfasst,
- diese erste Schaltstellung beibehalten wird, wenn das Strommessmittel den Adressierungsstrom oder - alternativ - den Teststrom erfasst, und
- wenn dies nicht der Fall ist, die Umschalteinheit in eine zweite Schaltstellung überführt wird, in der der Eingang der Umschalteinheit mit deren anderen Ausgang verbunden ist.

Bei diesem Aspekt der erfindungsgemäßen Detektion der korrekten Einspeisung von Adressierungsströmen durch Busknoten eines seriellen Datenbussystems wird erfindungsgemäß ferner vorgeschlagen ein Adressier-Busknoten für ein serielles Datenbussystem mit einem an eine Busleitung angeschlossenen Busmaster und mit mehreren aufeinanderfolgend an die Busleitung angeschlossenen Busknoten, von denen einige Adressier-Busknoten sind und andere als Standard-Busknoten mit bereits festgelegter Adresse ausgeführt sein können, wobei der Adressier-Busknoten zur Zuweisung seiner Adresse durch den Busmaster vorgesehen ist und aufweist
- ein Strommessmittel,
- eine Adressierungsstromquelle zum Einspeisen eines Adressierungsstroms in die Busleitung und durch diese zum Busmaster und zwar bei Erfassung durch das Strommessmittel und
- eine Ruhestromquelle zum Einspeisen eines Ruhestroms in die Busleitung und durch diese zum Busmaster, wobei die Ruhestromquelle mit der Adressierungsstromquelle identisch sein kann,
- eine Ansteuereinheit zur Ansteuerung zumindest der Adressierungsstromquelle zwecks Einspeisung des Adressierungsstroms durch wahlweise einen von zwei Knotenpunkten in die Busleitung,
- wobei das Strommessmittel zwischen den beiden Knotenpunkten angeordnet ist,
- wobei die Ansteuereinheit eine Auswerteeinheit zur Ermittlung desjenigen der beiden Knotenpunkte aufweist, bei dem bei Einspeisung des Adressierungsstroms oder eines Teststroms das Strommessmittel diesen Strom erfasst, und
- wobei der Adressierungsstrom durch denjenigen Knotenpunkt in die Busleitung einzuspeisen ist, bei dem das Strommessmittel den Adressierungsstrom oder - alternativ - zuvor den Teststrom erfasst hat.

Gemäß einer ersten Variante des erfindungsgemäßen Adressier-Busknotens weist dieser eine Umschalteinheit mit einem in Wirkverbindung mit der Adressierungsstromquelle stehenden Eingang und mit zwei Ausgängen auf, von denen der eine mit dem einen Knotenpunkt und der andere mit dem anderen Knotenpunkt verbunden ist, wobei der Eingang der Umschalteinheit wahlweise mit deren einen Ausgang oder mit deren anderen Ausgang in Wirkverbindung bringbar ist und wobei die Umschalteinheit auf Veranlassung der Ansteuereinheit in diejenige Umschaltstellung überführbar ist, in der das Strommessmittel einen durch die Umschalteinheit fließenden Adressierungsstrom oder Teststrom erfasst.

Gemäß einer weiteren Variante des erfindungsgemäßen Adressier-Busknotens weist dieser eine erste und eine zweite Adressierungsstromquelle auf, von denen die eine mit dem einen Knotenpunkt und die andere mit dem anderen Knotenpunkt verbunden ist, und eine Überwachungseinheit zur Ermittlung, in welchem der beiden Knotenpunkte bei Einspeisung eines Adressierungsstroms oder eines Teststroms das Strommessmittel diesen Strom erfasst, wobei der Adressierungsstrom von derjenigen Adressierungsstromquelle in die Busleitung einzuspeisen ist, die mit demjenigen Knotenpunkt verbunden ist, bei dem das Strommessmittel bei Einspeisung des Adressierungsstroms oder - alternativ - des Teststroms zuvor den Strom erfasst hat.

Zur besseren Orientierung werden hier zunächst folgende Richtungen auf dem Datenbus vereinbart: Die Betrachtungsrichtung von einem Busknoten aus ist so, dass alles, was sich in dem Datenbus zwischen Busknoten und Busmaster befindet, VOR dem betrachteten Busknoten und damit auf die Richtung des zum Busmaster fließenden Stroms bezogen stromab des betrachteten Busknotens befindet, und alles, was sich zwischen dem betrachteten Busknoten und dem Ende des Datenbusses befindet, sich NACH dem Busknoten und damit auf die Stromrichtung bezogen stromauf des betrachteten Busknotens befindet. Diese Definitionen gelten für die gesamte vorliegende Anmeldung.

Im Folgenden wird zunächst ein beispielhaftes Verfahren für die automatische Adressvergabe anhand eines standardkonformen LIN-Bus-Systems beschrieben. Ab dem Ende dieses Abschnitts wird die Erfindung beschrieben.

Im Gegensatz zu den Verfahren und Vorrichtungen der DE-B-10 147 512, EP-B-1 490 772 und US-B-9 331 866 kann erfindungsgemäß der Widerstandswert des Bus-Shunt-Widerstands dabei soweit abgesenkt, dass wieder Standardkonformität erreicht werden kann. Das Local Interconnect Network (LIN), auch LIN-Bus genannt, ist ein serielles Kommunikationssystem für die Vernetzung von Sensoren und Aktoren, d. h. ein Feldbus. LIN kommt dort zum Einsatz, wo die Bandbreite und Vielseitigkeit von CAN nicht benötigt wird. Typische Anwendungsbeispiele sind die Vernetzung innerhalb der Tür oder des Sitzes eines Kraftfahrzeugs. Der relevante Standard ist die ISO-Norm 17987-1, "Road vehicles - Local interconnect network (LIN) - Part 1-7".

Die Grundidee der hier beispielhaft beschriebenen Erfindung ist es nun, die Adressierungsstromquelle für den Selbsttest zu nutzen und so Anforderungen der ISO 26262 zu erfüllen. Hierzu wird nun abweichend von der technischen Lehre der DE-B-10 2010 026 431 nicht der von den nachfolgenden Adressier-Busknoten durch den jeweiligen Busknoten fließende Busstrom gemessen, sondern der den jeweiligen Adressier-Busknoten verlassende Summenstrom (i1, i2, i3), der sich aus dem Adressierungsstrom, der in diesem jeweiligen Adressier-Busknoten durch die Adressierungsstromquelle (Iql, Iq2, Iq3) dieses jeweiligen Adressier-Busknotens in die Datenleitung eingespeist wird, und dem von den nachfolgenden, also stromauf angeordneten Adressier-Busknoten durch den jeweiligen Adressier-Busknoten fließende Busstrom zusammensetzt. Das bedeutet architektonisch, dass der Bus-Shunt-Widerstand (R2) des jeweiligen Busknotens (SL1, SL2, SL3) jeweils vor der jeweiligen Autoadressierungsstromquelle (Iql, Iq2, Iq3) angeordnet ist, so dass der eigene Adressierungsstrom des jeweiligen Busknotens diesen Bus-Shunt-Widerstand (R2) durchströmen muss um zu dem Busmaster (ECU) zu gelangen, wo er gegen Masse abgeleitet wird.

Ein weiterer Aspekt der hier vorgestellten Erfindung ist es darüber hinaus, dass aus dem Ausgang jedes Adressier-Busknotens während des Adressvergabevorgangs im Gegensatz zu allen vorgenannten Schriften ein im Wesentlichen konstanter Ausgangsstrom (iⱼ) des betreffenden Busknotens (SLⱼ) in den vorausgehenden Datenbus in Richtung Busmaster (ECU) eingespeist wird.

Ein Problem stellen möglicherweise vorhandene Standard-Busknoten (CS1, CS2) dar, die keine Fähigkeit zur Autoadressierung im Sinne der Erfindung haben, also zuvor festgelegte Adressen aufweisen. Im Rahmen der Erfindung wird grundsätzlich davon ausgegangen, dass kein Mischverbau mit Adressier-Busknoten mit Autoadressierungsfähigkeiten entsprechend anderen Autoadressierungsverfahren stattfindet. Die Standard-Busknoten (CS1, CS2) ohne Fähigkeit zur Autoadressierung speisen mit ihrer Busstromquelle (S1, R3, d1) jeweils einen Busstrom, den Busknotengrundstrom, in den Datenbus in Richtung Busmaster (ECU) ein. Bevorzugt handelt es sich dabei um Busknoten (CS1, CS2), die nur einmal im Datenbus vorhanden sind und daher leicht aufgrund ihres Aussehens beispielsweise bei der Montage eines Kraftfahrzeugs voneinander durch die Monteure visuell unterscheidbar sind. Hierdurch ist eine Selbstadressierung bei der Montage dieser Busknoten beispielsweise in einem Kraftfahrzeug während dessen Montage nicht notwendig. Jeder dieser Standard-Busknoten (CS1, CS2) speist entsprechend dem LIN-Standard einen Grund-(Ruhe-)stromanteil in den Datenbus mittels einer Pull-Up-Stromquelle (S1, R3, d1) ein. Diese Standard-Busknoten (CS1, CS2) verursachen somit zusammen einen maximalen Grundstrom. Dieser Grundstrom kann durch die Adressier-Busknoten mit Autoadressierungsfähigkeit, im Folgenden als Autoadressier-Busknoten bezeichnet, aufgrund der Abgabe der Anzahl der Standard-Busknoten ohne Autoadressierungsfähigkeit abgeschätzt werden.

Es gibt zwei Extremkonfigurationen, an denen das sich daraus ergebende Problem erläutert werden kann. In beiden Extremkonfigurationen ist die Anzahl der Standard-Busknoten maximal, während die Anzahl der Autoadressier-Busknoten mit Autoadressierungsfähigkeit minimal ist:

### Konfiguration A

In der Konfiguration A befinden sich alle n Standard-Busknoten, die keine Fähigkeit zur Autoadressierung haben, vom Busmaster (ECU) aus gesehen hinter z. B. lediglich zwei Autoadressier-Busknoten, die die Fähigkeit zur Autoadressierung gemäß der hier beschriebenen Erfindung haben. Die maximale Anzahl n der Standard-Busknoten hinter den zwei Autoadressier-Busknoten mit Autoadressierungsfähigkeit ist dann (n+2)<I_{max/}Iₖ. Hierbei ist Iₘₐₓ der maximale Stromwert, den der Busmaster (ECU) in der Autoadressierungsphase nach dem ISO-Standard aufnehmen kann. Vorzugsweise wird der maximale Stromwert Iₘₐₓ ein wenig kleiner als der echte maximale Stromwert des Busmasters (ECU) gewählt, um Fertigungsschwankungen und Betriebsparameterschwankungen abzufangen. Iₖ ist der obere Grenzwertwert für den Wert des Busknotengrundstroms, den die Gesamtheit aller Standard-Busknoten ohne Autoadressierungsfähigkeit in den Datenbus einspeist. Vorzugsweise speist jeder der Standard-Busknoten ohne Autoadressierung in etwa den gleichen Busknotengrund-(-ruhe-)strom in den Datenbus ein. Die Standard-Busknoten erzeugen dann am Eingang des zweiten Autoadressier-Busknotens mit Autoadressierungsfähigkeit einen maximalen Grundstrom von I_{G}=n^{∗}Iₖ. Es verbleibt für die Autoadressierung durch die Autoadressier-Busknoten mit Autoadressierung ein Strombereich von Iₐₘₐₓ=2^{∗}Iₖ für den maximalen Adressierungsstrom jedes Autoadressier-Busknotens. Dieser Strombereich für den maximalen Adressierungsstrom jedes Autoadressier-Busknotens kann dann zur Autoadressierung genutzt werden. Hierzu können die Autoadressier-Busknoten in einer vorgelagerten Phase A diesen Grundstrom durch ihren jeweiligen Bus-Shunt-Widerstand (R2) messen und dann den Strombereich für den maximalen Adressierungsstrom jedes Autoadressier-Busknotens ermitteln und anschließend zur Autoadressierung verwenden. Hierdurch wird der Spannungsabfall über die Bus-Shunt-Widerstände (R2) maximal. Diese können daher minimiert werden. Dies steht im Gegensatz zur DE -B-10 2010 026 431, die dieses Problem nicht löst.

### Konfiguration B

In der Konfiguration B befinden sich alle n Standard-Busknoten, die keine Fähigkeit zur Autoadressierung haben, vom Busmaster (ECU) aus gesehen vor den z. B. lediglich zwei Autoadressier-Busknoten, die die Fähigkeit zur Autoadressierung gemäß der hier beschriebenen Erfindung haben. Im Gegensatz zur Konfiguration A können die Autoadressier-Busknoten nun jedoch keine Information über die Anzahl der Standard-Busknoten in Richtung Busmaster (ECU) vor ihnen, d. h. stromab von ihnen, erhalten. Somit besteht die Gefahr, dass der von den Autoadressier-Busknoten verwendete maximale Adressierungsstrom in Kombination mit dem am Busmaster ankommenden Grundstrom aller vorausgehenden Busknoten im Datenbus zu groß ist, was zu einer Fehlermeldung führen würde. Die maximale Anzahl n der Standard-Busknoten hinter den zwei Autoadressier-Busknoten mit Autoadressierungsfähigkeit ist aber wieder (n+2)<I_{max/}Iₖ. Hierbei ist Iₘₐₓ wieder der maximale Stromwert, den der Busmaster (ECU) in der Autoadressierungsphase aufnehmen kann. Vorzugsweise wird der maximale Stromwert Iₘₐₓ auch hier ein wenig kleiner als der echte maximale Stromwert des Busmasters (ECU) gewählt, um Fertigungsschwankungen und Betriebsparameterschwankungen abzufangen. Iₖ ist der obere Grenzwert für den Wert des Busknotengrundstroms, den die Gesamtheit aller Standard-Busknoten in den Datenbus einspeist. Vorzugsweise speist auch hier wieder jeder der Standard-Busknoten in etwa den gleichen Busknotengrundstrom in den Datenbus ein. Die Standard-Busknoten erzeugen dann am Eingang des Busmasters (ECU) einen maximalen Grundstrom von I_{G}=n^{∗}Iₖ. Es verbleibt für die Autoadressierung durch die diesen nachfolgenden Autoadressier-Busknoten mit Autoadressierung wieder nur ein Strombereich von 2^{∗}Iₖ für den Adressierungsstrom (Iₐ). Über diesen Strombereich können die nachfolgenden Autoadressier-Busknoten mit Autoadressierungsfähigkeit jedoch keine Information erhalten. Dieser Strombereich kann zwar zur Autoadressierung genutzt werden, muss jedoch den Autoadressier-Busknoten mit Autoadressierungsfähigkeit nun durch den Busmaster (ECU) mitgeteilt werden. Dies kann so geschehen, dass der Busmaster allen Busknoten die Anzahl der Standard-Busknoten mittels einer an alle Busknoten gerichteten Botschaft mitteilt oder einen geeigneten Adressierungsstromwert mittels eines solchen Befehls vorab mitteilt. Hierdurch wird es möglich, den Adressierungsstrom in den jeweiligen Autoadressier-Busknoten zu maximieren.

### Konfiguration C

Konfiguration C ist eine Mischung von Konfiguration A und Konfiguration B.

Es befinden sich dann Standard-Busknoten vor dem, d. h. stromab und hinter dem, d. h. stromauf der Autoadressier-Busknoten mit Autoadressierungsfähigkeit in dem seriellen Datenbus. In dem Fall muss der Busmaster (ECU) nur die Anzahl n der vor den Autoadressier-Busknoten liegenden Standard-Busknoten übertragen. Die Autoadressier-Busknoten können durch eine Vermessung des Grundstroms durch ihren Bus-Shunt-Widerstand bezogen auf die nachfolgenden Busknoten so den Gesamtgrundstrom durch Summierung dieses Grundstroms mit dem n-fachen des Busknotengrundstroms Iₖ ermitteln. Alternativ kann der Busmaster (ECU) auch einen anderen Wert übertragen, aus dem sich der Grundbusstrom errechnen lässt. Auf dieser Basis kann dann wieder jeder Autoadressier-Busknoten den maximalen Adressierungsstrom Iₐₘₐₓ berechnen und maximiert einstellen.

Bevor die Busknotenadressen vergeben werden, signalisiert also der Busmaster (ECU) bevorzugt an alle Busknoten, welche Konfiguration der oben angegebenen Konfigurationen vorliegt und wie viele Standard-Busknoten im System vorhanden sind, die keine Fähigkeit zur Autoadressierung haben und/oder wie groß der erwartete Grundbusstrom ist.

Mit Beginn der Autoadressierung zieht der Bus-Master (ECU) die Datenleitung mittels eines Schalters (SB) oder Ähnliches nach Masse. Die dafür verwendete Stromsenke kann den maximalen Stromwert Iₘₐₓ aufnehmen. Bei Überschreitung dieses Wertes durch den Betrag des Busstroms in den Busmaster (ECU) hinein, kann der Bus-Master (ECU) einen Kurzschluss annehmen und entsprechende Signalisierungen und Fehlermeldungen erzeugen. Daher darf dieser maximale Stromwert Iₘₐₓ im Normalbetrieb betragsmäßig nicht überschritten werden.

In Abhängigkeit von der Anzahl der Standard-Busknoten und des standardgemäß vorgegebenen maximalzulässigen Busstroms Iₘₐₓ kann jeder Busknoten dann den maximalen Adressierungsstrom Iₐₘₐₓ seiner jeweiligen Adressierungsstromquelle (Iql, Iq2, Iq3) berechnen, der noch zulässig ist, ohne den maximal zulässigen Adressierungsstrom (Iₘₐₓ) zu überschreiten. Bevorzugt wird dieser Wert durch die empfangene Anzahl n der Standard-Busknoten ohne Autoadressierungsfähigkeit im jeweiligen Autoadressier-Busknoten mit Autoadressierungsfähigkeit vorgegeben. Dabei wird bevorzugt noch eine Sicherheitsmarge berücksichtigt, so dass der tatsächlich eingestellte Autoadressierungsstrom Iₐₘₐₓ der Autoadressierungsstromquellen der Autoadressier-Busknoten (SL1, SL2, SL3) geringer ist, als der tatsächlich maximal zulässige Autoadressierungsstrom.

Es muss nun sichergestellt werden, dass der maximal zulässige Busstrom Iₘₐₓ nicht überschritten wird. Im Gegensatz zur DE-B-10 2010 026 431 wird nun nicht der in den Autoadressier-Busknoten von den nachfolgenden Busknoten kommende Grundstrom und Adressierungsstrom erfasst und bei Abweichung vom Grundstrom die eigene Adressierungsstromquelle deaktiviert.

Vielmehr wird der Summenstrom (i1, i2, i3) erfasst, der den jeweiligen Autoadressier-Busknoten über den Datenbus in Richtung Bus-Master (ECU) verlässt. Dieser setzt sich zusammen aus dem von den nachfolgenden Autoadressier-Busknoten und ggf. Standard-Busknoten eingespeisten Busstrom zuzüglich dem selbst eingespeisten Adressierungsstrom.

Hierzu misst der jeweilige Autoadressier-Busknoten (Sl1, SL2, SL3) den ausgehenden Busstrom (i1, i2, i3), der kommend von den nachfolgenden Autoadressier-Busknoten (Sl2, Sl3) den Bus-Shunt (R2) des jeweiligen Autoadressier-Busknotens (Sl1, SL2, SL3) durchfließt und an dem Ausgang des jeweiligen Busknotens diesen wieder in Richtung auf den Busmaster (ECU) verlässt. Der jeweilige Autoadressier-Busknoten (SL1, SL2, SL3) steuert nun seine eigene Adressierungsstromquelle (Iql, Iq2, Iq3) so, dass die Summe aus einkommendem Busstrom der nachfolgenden Busknoten (Sl2, Sl3) und Adressierungsstrom der eigenen Adressierungsstromquelle (Iql, Iq2, Iq3) einem vorgegebenen Summenstrom (Iₛ) entspricht. Die Amplitude des Adressierungsstroms (Iₐ) wird dabei so eingestellt, dass der maximale Busstrom Iₘₐₓ durch den Betrag des ausgehenden Busstroms (i1, i2, i3) nicht überschritten werden kann. Somit bleibt der Busstrom (1, i2, i3), der den jeweiligen Busknoten (SL1, SL2, Sl3) verlässt konstant und wird durch den jeweiligen Busknoten (SL1, SL2, Sl3) nicht über einen Maximalwert erhöht. Eine Überlastung der Busmaster-Stromsenke während des Adressvergabeverfahrens ist damit ausgeschlossen.

In diesem Verfahren detektiert also jeder der am Adresszuteilungsverfahren teilnehmenden Autoadressier-Busknoten einen vom Grundstrom abweichenden zusätzlichen Strom. Dieser zusätzliche Strom setzt sich zusammen aus dem eigenen Adressierungsstrom des jeweiligen Busknotens und dem Adressierungsstrom des dem jeweiligen Autoadressier-Busknoten (SL1, SL2, SL3) nachfolgenden Busknotens (Adressier-Busknoten und ggf. Standard-Busknoten).

Damit es nicht zu einer Übersteuerung des Ausgangsstromes (i1, i2, i3) über Iₘₐₓ kommt, regelt der jeweilige Busknoten seinen Ausgangsstrom (i1, i2, i3) in Richtung Busmaster (ECU) in der Art, dass er stets dem vorgesehenen Maximalwert des Adressierungsstromes Iₐₘₐₓ plus dem Grundstrom entspricht. Hierfür ist die Adressierungsstromquelle (Iql, Iq2, Iq3) innerhalb jedes Autoadressier-Busknotens (SL1, Sl2, Sl3) mit Autoadressierungsfähigkeit steuerbar ausgelegt. Der Adressierungsstrom der jeweiligen Adressierungsstromquelle (Iql, Iq2, Iq3) hängt dann zum einen von dem zuvor ermittelten Maximalwert (Iₐₘₐₓ) und zum anderen von einem Regelsignal ab, das mittels einer Regelstrecke (F) und einer Messvorrichtung (R2, D1) aus dem Ausgangsstrom (i1, i2, i3) des jeweiligen Busknotens (SL2) in Richtung Busmaster (ECU) ermittelt wird.

Die Regelstrecke beginnt also bei einer Messvorrichtung, vorzugsweise einem Bus-Shunt-Widerstand (R2), der demjenigen Busknoten, der vom Busmaster (ECU) aus gesehen zwischen dem jeweiligen Busknoten (SL1, SL2, SL3) vorausgehend in den Datenbus eingefügt ist, vorgelagert ist. Dort wird der Busstrom aus dem jeweiligen Busknoten in Richtung Busmaster (ECU) in einen Spannungswert gewandelt. Dieser wird durch eine Messvorrichtung, z.B. einen Operationsverstärker (D1) erfasst und ggf. nach Filterung (F) zu einem Regelwert umgewandelt, mit dem die jeweilige Autoadressierungsstromquelle (Iql, Iq2, Iq3) dann so gesteuert werden kann, dass der Busstrom (i1, i2, i3) in Richtung Busmaster (ECU) in dieser Adressvergabephase konstant gehalten wird.

Hierbei tritt innerhalb des jeweiligen Busknotens (SL1, SL2, Sl3) bei geeigneter Konstruktion der notwendigen Regelschleife eine Regelgröße, der Regelwert, vorzugsweise als Ausgangssignals des besagten Filters (F) auf. Zur Vereinfachung sei hier beispielhaft angenommen, dass diese Regelgröße direkt proportional zum jeweiligen Ausgangsstrom (i1, i2, i3) des jeweiligen Autoadressier-Busknotens (Sl1, Sl2, Sl3) in Richtung Busmaster (ECU) sei.

Überschreitet dieser Regelwert nach Ablauf der besagten vorgegebenen Initialisierungszeit immer noch einen vorgegebenen Schwellwert (SW), liefert also die eigene Adressierungsstromquelle (Iql, Iq2, Iq3) den vorgegebenen Ausgangsstrom in Richtung Busmaster (ECU), so ist der jeweilige Autoadressier-Busknoten vom Busmaster (ECU) aus gesehen der letzte in der Kette der Autoadressier-Busknoten. Der betreffende Autoadressier-Busknoten übernimmt dann die vom Busmaster (ECU) zuvor oder anschließend an alle Autoadressier-Busknoten (SL1, SL2, Sl3) übermittelte zu vergebende Busknotenadresse als seine nunmehr gültige Busknotenadresse und nimmt an weiteren Initialisierungsdurchläufen nicht mehr teil, es sei denn, dass durch einen Rücksetzbefehl oder eine sonstige Rücksetzbedingung die erhaltene Busknotenadresse für ungültig erklärt wird. Die anderen Autoadressier-Busknoten, die noch keine gültige Busknotenadresse besitzen, nehmen an folgenden Initialisierungsdurchläufen teil.

Bevorzugt erfolgt die Regelung des Ausgangsstromwerts der Autoadressierungsstromquellen (Iql, Iq2, Iq3) innerhalb der Autoadressier-Busknoten (SL1, SL2, SL3) mittels eines Filters (F) gefiltert. Bevorzugt bildet die Regelschleife einen PI-Regler. Diese Filterung ist notwendig, damit es nicht zu Überschwingern bei der Erzeugung des Adressierungsstroms durch die Gesamtheit der Autoadressier-Busknoten (SL1, Sl2, Sl3) am Busmaster (ECU) kommt. Würde dies geschehen, so kann der maximal zulässige Busstrom Iₘₐₓ überschritten werden und der Busmaster (ECU) einen Kurzschluss erkennen, was zu vermeiden ist.

Daher ist es vorteilhaft und bevorzugt zumindest ein Tiefpassfilter (F) in den Regelkreis jedes Autoadressier-Busknotens (SL1, SL2, Sl3) aufzunehmen.

In einer weiteren, bevorzugten Ausprägung der Erfindung wird das Filter (F) nichtlinear ausgeführt. Dabei sollte bevorzugt eine erste Regelzeitkonstante (τ₁) des nicht linearen Filters (F) für ein Erhöhen des Adressierungsstroms der jeweiligen Adressierungsstromquelle (Iql, Iq2, Iq3) des jeweiligen Busknotens (SL1, Sl2, Sl3) größer sein als eine zweite Regelzeitkonstante τ₂) des nicht linearen Filters (F) für ein Erniedrigen des Adressierungsstroms der jeweiligen Adressierungsstromquelle (Iql, Iq2, Iq3) des jeweiligen Busknotens (SL1, SL2, SL3). Es hat sich gezeigt, dass bei m Autoadressier-Busknoten die für die Verminderung des Adressierungsstromes der jeweiligen Adressierungsstromquelle (Iql, Iq2, Iq3) definierende zweite Zeitkonstante τ₂) um einen Faktor m kürzer sein sollte als die erste Zeitkonstante (τ₁), die die Erhöhung des Adressierungsstromes der jeweiligen Adressierungsstromquelle (Iql, Iq2, Iq3) definiert. Dies führt dazu, dass der Adressierungsstrom der jeweiligen Adressierungsstromquelle (Iql, Iq2, Iq3) des jeweiligen Busknotens (SL1, SL2, Sl3) schneller erniedrigt als erhöht wird. Somit regeln nachfolgende Autoadressier-Busknoten ihren Adressierungsstrom schneller herunter als dieser von anderen Autoadressier-Busknoten heraufgeregelt wird. Somit ist eine Konstanz des Busstroms, zumindest aber ein permanentes Unterschreiten eines maximalen Busstromwerts Iₘₐₓ während der Adressierungsphase sichergestellt. Simulationen haben ergeben, dass die erste Zeitkonstante (τ₁), mit der die Adressierungsstromquelle (Iql, Iq2, Iq3) des jeweiligen Autoadressier-Busknotens (SL1, Sl2, Sl3) herauf geregelt wird, bevorzugt um einen Faktor 10, besser um einen Faktor 100 größer sein sollte, als die zweite Zeitkonstante (τ₂), mit der die Adressierungsstromquelle (Iql, Iq2, Iq3) des jeweiligen Autoadressier-Busknotens (SL1, SL2, Sl3) herunter geregelt wird.

In einem typischen LIN-Bus sind aber, wie bereits beschrieben, erfahrungsgemäß auch Standard LIN-Busknoten ohne Autoadressierungsfähigkeit vorhanden. Diese liefern einen konstanten Dauerstrom während der Adressierungsphase in den Busmaster (ECU) hinein. Im Gegensatz zu anderen Verfahren, die Grundstrom bezogen sind, kann nun die Schwelle für das Erkennen der letzten Busposition für den in dem betreffenden Initialisierungsdurchlauf mit einer Busknotenadresse zu versehenden Autoadressier-Busknoten sehr hoch gelegt werden.

Nachdem ein Autoadressier-Busknoten mit Autoadressierungsfähigkeit auf diese Weise eine gültige Busknotenadresse erhalten hat, nutzt er seine Adressierungsstromquelle bevorzugt wie eine Busknotengrundstromquelle und verhält sich dann wie ein Busknoten ohne Autoadressierungsfähigkeit. In den Figuren sind als mögliche Alternative trotzdem separate Busknotengrundstromquellen (S1, R3, d1) in den Autoadressier-Busknoten (SL1, SL2, SL3) eingezeichnet. Diese würden dann entfallen können. Dieser Zustand eines Autoadressier-Busknotens nach der erfolgten Vergabe einer gültigen Busknotenadresse wird bevorzugt nur durch ein Rücksetzen des Autoadressier-Busknotens oder eine Löschung der Gültigkeit der Busknotenadresse geändert. Im nächsten Initialisierungsdurchlauf erhält daher der dann vom Busmaster (ECU) aus gesehen letzte Autoadressier-Busknoten eine gültige Busknotenadresse und verhält sich ab da wie ein Standard-Busknoten, nimmt also an dem weiteren Autoadressierungsverfahren nicht mehr teil. Die Autoadressier-Busknoten, die noch keine gültige Busknotenadresse erhalten haben, verhalten sich weiterhin wie Autoadressier-Busknoten. Damit endet ein Initialisierungsdurchlauf. Der Busmaster löst daraufhin einen weiteren Initialisierungsdurchlauf aus, bei dem dann der vom Busmaster (ECU) aus gesehen bisherige vorletzte Autoadressier-Busknoten, der nun der vom Busmaster aus gesehen letzte Autoadressier-Busknoten ist, der sich als solcher verhält, eine gültige Busknotenadresse erhält, und so weiter. Dieses wiederholte Auslösen der Initialisierungsdurchläufe durch den Busmaster (ECU) und die Vergabe einer gültigen Busknotenadresse in einem solchen Initialisierungsdurchlauf an den vom Busmaster aus gesehen letzten Autoadressier-Busknoten, der sich als solcher verhält, wird so lange durchgeführt, bis alle Autoadressier-Busknoten eine gültige Busknotenadresse vom Busmaster (ECU) erhalten haben. Um dies festzustellen, prüft bevorzugt der Busmaster (ECU) nach jedem Initialisierungslauf, ob der adressierte Autoadressier-Busknoten, der gerade eine gültige Busknotenadresse erhalten haben soll, antwortet. Bevorzugt sendet der adressierte Autoadressier-Busknoten dann eine Zufallszahl an den Busmaster (ECU) auf Veranlassung des Busmasters (ECU) hin. Sind - aus welchen Gründen auch immer - zwei Autoadressier-Busknoten aktiv, so kommt es zu Buskollisionen. Diese können von den Busknoten detektiert werden und an den Busmaster (ECU) signalisiert werden. In gewissen Fällen, wenn die Antwort vorbestimmbar ist, kann auch der Busmaster (ECU) eine Buskollision direkt feststellen. Der Busmaster (ECU) kann hierdurch entweder direkt oder indirekt eine Buskollision erkennen und ggf. die Initialisierung der betreffenden Busknotenadresse wiederholen. Dafür ist es sinnvoll, wenn der Busmaster (ECU) einen Löschbefehl für die zuletzt vergebene Busknotenadresse an alle Busknoten absetzen kann.

Während der Adressvergabe kann nun der Busstrom durch den Bus-Shunt-Widerstand (R2) auf verschiedene Bedingungen geprüft werden:
a) Liegt der Spannungsabfall über den Bus-Shunt-Widerstand (R2) über einem maximalen Spannungsabfallschwellwert, so liegt im nachfolgenden Datenbusabschnitt ein Kurzschluss nach Versorgungsspannung vor. In dem Fall schaltet der betroffene Busknoten bevorzugt alle Stromquellen ab, um eine Beschädigung des Systems auszuschließen. In der Regel erkennt dann aber auch der Busmaster (ECU) diesen Kurzschluss.
b) Ist der Spannungsabfall über den Bus-Shunt-Widerstand 0V, so ist typischerweise der Messeingang kurzgeschlossen.
c) Liegt der Spannungsabfall über den Bus-Shunt-Widerstand (R2) unter dem maximalen Spannungsabfallschwellwert, aber über einem zweiten Spannungsabfallschwellwert, so ist der Bus-Shunt-Widerstand vermutlich von den nachfolgenden Busknoten getrennt und der Messeingang noch mit den nachfolgenden Busknoten verbunden, die diese Messleitung zur Versorgungsspannung hin potenzialmäßig hoch ziehen.
d) Liegt der Spannungsabfall über den Bus-Shunt-Widerstand (R2) im Bereich des Spannungsabfalls des Grundstroms, so arbeitet die eigene Adressierungsstromquelle (Iql, Iq2, Iq3) des betreffenden Busknotens nicht, obwohl er der letzte ist. Der Busknoten kann dies dem Busmaster (ECU) beispielsweise dadurch signalisieren, dass er eine Buskollision provoziert, indem er die zu vergebene Busknotenadresse als gültige Busknotenadresse übernimmt. Dies führt dann dazu, dass bei der Überprüfung der korrekten Busknotenadressierung zwei Autoadressier-Busknoten dem Busmaster antworten, was dieser dann erkennen kann. Es wird somit ein Verfahren zur Vergabe von Busknotenadressen innerhalb eines seriellen Datenbusses mit einer Kette von Busknoten (SL1, SL2, SL3) und einem Busmaster (ECU) vorgeschlagen, bei dem die Busknoten (SL1, SL2, SL3) Autoadressier-Busknoten oder Standard-Busknoten sein können und der Datenbus einen Busmaster (ECU) aufweist. Jeder Busknoten (SL2, SL3) weist einen vorausgehenden Busknoten (SL1, SL2) auf, wenn er nicht der erste Busknoten (SL1) ist. Jeder Busknoten (SL2, SL3) ist mit seinem vorausgehenden Busknoten (SL1, SL2) durch den Datenbus verbunden, wenn er nicht der erste Busknoten (SL1) ist. Der erste Busknoten (SL1) ist mit dem Busmaster (ECU) durch den Datenbus verbunden. Jeder Busknoten (SL2, SL3) sendet einen Busknotenausgangsstrom (i2, i3) an seinen vorausgehenden Busknoten (SL1, Sl2) über einen Busknoten-Ausgang, wenn er nicht der erste Busknoten (SL1) ist. Der erste Busknoten (SL1) sendet einen Busknotenausgangsstrom (i1) an den Busmaster (ECU) über einen Busknoten-Ausgang. Jeder Busknoten (SL1, SL2) empfängt einen Busknoteneingangsstrom (i2, i3) von seinen nachfolgenden Busknoten (SL2, Sl3) über einen Busknoten Eingang, wenn er nicht der letzte Busknoten (SL3) ist. Das Verfahren umfasst die Schritte:
   - Bestimmung des maximalen Adressierungsstroms (Iₐₘₐₓ);
   - Durchführen einer Initialisierungssequenz mit folgenden Schritten für jeden Autoadressier-Busknoten der Busknoten (SL1, Sl2, SL3), der noch keine gültige Busknotenadresse besitzt bis alle Autoadressier-Busknoten der Busknoten (Sl1, Sl2, Sl3) über eine gültige Busknotenadresse verfügen:
      ∘ Signalisierung einer zu vergebenden Busknotenadresse an alle Autoad ressier-Busknoten;
      ∘ Durchführung der folgenden Schritte durch alle Autoadressier-Busknoten (SL1, SL2, SL3), im Folgenden als betreffender Autoadressier-Busknoten (SLj) bezeichnet:
         ▪ Empfang des besagten Autoadressierungskommandos vom Bus-master (ECU) durch den betreffenden Autoadressier-Busknoten (SLj);
         ▪ Empfang der zu vergebenden Busknotenadresse vom Busmaster (ECU) durch den betreffenden Autoadressier-Busknoten (SLj);
         ▪ Ausschalten ggf. vorhandener Busknotengrundstromquellen (S1, R3, d1) innerhalb des jeweiligen Autoadressier-Busknotens (SLj)
         ▪ Empfang eines Startsignals für die Vergabe der zu vergebenden Busknotenadresse vom Busmaster (ECU) durch den betreffenden Autoadressier-Busknoten (SLj) und Start eines Zeitgebers durch den betreffenden Autoadressier-Busknoten (SLj);
         ▪ Einspeisen des von den nachfolgenden Busknoten (SL(j+1), SL(j+2)...) empfangenen Buseingangsstroms (i₍ⱼ₊₁₎) in den Busknotenausgang des betreffenden Autoadressier-Busknotens (SLj) als Teil des Busausgangsstroms (iⱼ) des betreffenden Autoadressier-Busknotens (SLj);
         ▪ Erfassen des Werts des Busknotenausgangsstroms (iⱼ) des betreffenden Autoadressier-Busknotens (SLⱼ) mittels Messmitteln (R2, D1, D3);
         ▪ Erzeugung eines Regelsignals (rwⱼ) aus dem erfassten Wert des Busknotenausgangsstroms (iⱼ) des betreffenden Autoadressier-Busknotens (SLj) mittels Mitteln zum Regeln (F);
         ▪ Ausregeln des Busknotenausgangsstroms (iⱼ) durch den betreffenden Autoadressier-Busknoten (SLj), mittels einer geregelten Autoadressierungsstromquelle (Iqj), deren Adressierungsstrom einen Anteil des Busausgangsstromes (iⱼ) darstellt, auf einen vorgegebenen Summenstromwert (I_{ref}) in Abhängigkeit von dem erzeugten Regelsignal (rwj),
         ▪ wobei eine Erhöhung des Adressierungsstroms der geregelten Autoadressierungsstromquelle (Iqj) des betreffenden Autoadressier-Busknotens (SLj) mit einer ersten Zeitkonstante (τ₁) erfolgt und
         ▪ wobei eine Erniedrigung des Adressierungsstroms der geregelten Autoadressierungsstromquelle (Iqj) des betreffenden Autoadressier-Busknotens (SLj) mit einer zweiten Zeitkonstante τ₂) erfolgt und
         ▪ wobei die zweite Zeitkonstante τ₂) kleiner ist als die erste Zeitkonstante (τ₁) ist;
         ▪ Vergleichen des Regelwerts (rj) des betreffenden Autoadressier-Busknotens (SLj) mit einem Schwellwert (SWj) des betreffenden Autoadressier-Busknotens (SLj);
         ▪ Einfrieren der Regelung der Adressierungsstromquelle (Iqj) des betreffenden Autoadressier-Busknotens (SLj) zu einem ersten Zeitpunkt t₁ nach dem Start des Zeitgebers;
         ▪ Übernahme der zu vergebenden Busknotenadresse vom Busmaster (ECU) als gültige Busknotenadresse des betreffenden Autoadressier-Busknotens (SLj), wenn eine Mindestzeit seit dem Start des Zeitgebers vergangen ist und wenn der Vergleich des Regelwerts (rj) mit einem Schwellwert (SWj) ergibt, dass der Adressierungsstrom der Adressierungsstromquelle (Iqj) des betreffenden Autoadressier-Busknotens (SLj) betragsmäßig oberhalb eines Stromschwellwertes liegt und Konfiguration des betreffenden Autoadressier-Busknotens (SLj) als Standard-Busknoten ohne Autoadressierungsfähigkeit mit der zu vergebenen Busknotenadresse als Busknotenadresse des betreffenden Autoadressier-Busknotens (SLj) zu einem zweiten Zeitpunkt t₂ nach dem ersten Zeitpunkt t₁, wodurch dieser Autoadressier-Busknoten (SLj) bis auf Weiteres nicht mehr an folgenden Initialisierungssequenzen teilnimmt.
      ∘ Überprüfung der erfolgreichen Adressvergabe durch den Busmaster (ECU);
      ∘ Ggf. Löschung der Gültigkeit der letzten vergebenen Busknotenadresse, wodurch die betreffenden Autoadressier-Busknoten (SLj) sich wieder wie Autoadressier-Busknoten (SLj) ohne gültige Busknotenadresse verhalten;
      ∘ Überprüfung ob alle Autoadressier-Busknoten eine gültige Busknotenadresse erhalten haben;
      ∘ Durchführung einer weiteren Initialisierungssequenz, wenn nicht alle Autoadressier-Busknoten eine gültige Busknotenadresse erhalten haben.

In einer Variante des vorgeschlagenen Verfahrens ist die zweite Zeitkonstante (τ₂) um einen Faktor größer als 10, bevorzugt größer als 100 kleiner als die erste Zeitkonstante (τ₁). In einer anderen Variante des Verfahrens hängt die erste Zeitkonstante (τ₁) innerhalb des betreffenden Autoadressier-Busknotens (SLj) von dem mittels Messmitteln (R2, D1, D3) erfassten Werts des Busknotenausgangsstroms (iⱼ) des betreffenden Autoadressier-Busknotens (SLⱼ) ab. Beispielsweise ist es vorteilhaft, wenn die erste Zeitkonstante (τ₁) zu Beginn, wenn der Gesamtstrom durch den Bus-Shunt-Widerstand noch klein ist sehr kurz ist und somit die Adressierungsstromquelle des jeweiligen Autoadressier-Busknotens sehr schnell den Strom erhöht, während später der Adressierungsstrom der Autoadressierungsstromquelle langsam erhöht wird. Es ist also denkbar, dass die erste Zeitkonstante (τ₁) innerhalb des betreffenden Autoadressier-Busknotens (SLj) von dem mittels Messmitteln (R2, D1, D3) erfassten Werts des Busknotenausgangsstroms (iⱼ) des betreffenden Autoadressier-Busknotens (SLⱼ) in der Art abhängt, dass der Wert der ersten Zeitkonstante (τ₁) unterhalb eines Schwellwerts einen ersten Wert und oberhalb des Schwellwerts einen zweiten Wert besitzt. Ebenso ist es natürlich denkbar, dass die zweite Zeitkonstante (τ₂) innerhalb des betreffenden Autoadressier-Busknotens (SLj) von dem mittels Messmitteln (R2, D1, D3) erfassten Werts des Busknotenausgangsstroms (iⱼ) des betreffenden Autoadressier-Busknotens (SLⱼ) abhängt.

Um nun eine Vertauschung des LIN-Eingangs mit dem LIN-Ausgang detektieren zu können, umfasst eine Variante des Verfahrens bevorzugt die Überprüfung des erfassten Werts des Busknotenausgangsstroms (iⱼ) des betreffenden Autoadressier-Busknotens (SLⱼ) auf Plausibilität und Einleitung von Maßnahmen falls der erfasste Wert des Busknotenausgangsstroms (iⱼ) des betreffenden Autoadressier-Busknotens (SLⱼ) nicht plausibel ist.

In einer weiteren Verfeinerung kann dann als Gegenmaßnahme eine Neubestimmung des Einspeisepunkts des Adressierungsstroms erfolgen, falls der erfasste Wert des Busknotenausgangsstroms (iⱼ) des betreffenden Autoadressier-Busknotens (SLⱼ) nicht plausibel ist.

Neben diesen kompensierenden Maßnahmen kann auch eine Signalisierung eines Fehlers über den Datenbus nach Aufforderung durch einen Bus-Master (ECU) erfolgen, falls der erfasste Wert des Busknotenausgangsstroms (iⱼ) des betreffenden Autoadressier-Busknotens (SLⱼ) nicht plausibel ist.

Eine weitere Maßnahme, die zur Stabilität des Regelkreises notwendig ist, kann in einer Verfeinerung der Durchführung des Schritts des Erfassens des Werts des Busknotenausgangsstroms (iⱼ) des betreffenden Autoadressier-Busknotens (SLⱼ) mittels Messmitteln (R2, D1, D3) sein. Bevorzugt erfolgt ein Erfassen des Werts des Busknotenausgangsstroms (iⱼ) des betreffenden Autoadressier-Busknotens (SLⱼ) mittels Messmitteln (R2, D1, D3) mit einem ersten Vorzeichen, falls der erfasste Wert des Busknotenausgangsstroms (iⱼ) des betreffenden Autoadressier-Busknotens (SLⱼ) plausibel ist, und ein Erfassen des Werts des Busknotenausgangsstroms (iⱼ) des betreffenden Autoadressier-Busknotens (SLⱼ) mittels Messmitteln (R2, D1, D3) mit einem zweiten Vorzeichen, das zum ersten Vorzeichen invertiert ist, falls der erfasste Wert des Busknotenausgangsstroms (iⱼ) des betreffenden Autoadressier-Busknotens (SLⱼ) nicht plausibel ist.

Eine weitere verfahrenstechnische Maßnahme kann die Verwendung einer vorbestimmten Fehleradresse als gültige Busknotenadresse des betreffenden Autoadressier-Busknotens (SLj) sein, falls der erfasste Wert des Busknotenausgangsstroms (iⱼ) des betreffenden Autoadressier-Busknotens (SLⱼ) nicht plausibel ist. Diese kann konstruktiv vorbestimmt sein oder beispielsweise per Broadcast-Message durch den Bus-Master (ECU) vorgegeben werden.

Es wird somit ein Datenbussystem mit Busknoten (SL1, SL2, SL3) für einen seriellen Datenbus vorgeschlagen, die jeweils einen Bus-Shunt-Widerstand (R2) aufweisen, der jeweils in den Datenbus eingefügt ist. Des Weiteren sollen sie eine Adressierungsstromquelle (Iql, Iq2, Iq3) zur Ermittlung der Busposition des Busknotens im Datenbus aufweisen, die einen Adressierungsstrom in der Art in den Datenbus geregelt zusätzlich einspeisen kann, dass der Gesamtstrom (i1, i2, i3) durch den Bus-Shunt-Widerstand (R2) des Busknotens (SL1, SL2, SL3) einem vorgegebenen oder berechneten oder sonst wie bestimmten Summenstrom (I_{ref}) entspricht. Die Regelung erfolgt dabei über den besagten Regelkreis (R2, D1, D3, F, Iq1, Iq2, Iq3). Dabei durchströmt der Adressierungsstrom den Bus-Shunt-Widerstand (R2) des betreffenden Autoadressier-Busknotens. Eine Variante des vorgeschlagenen Busknotens verfügt dabei über Mittel (R2, D1), um den Strom durch den Bus-Shunt-Widerstand (R2) zu detektieren, was die Erfassung eines Messwerts umfassen kann. Dieser detektierte Strom durch den Bus-Shunt-Widerstand (R2) kann in der Weise für einen Selbsttest genutzt werden, dass die oben beschriebenen Fehler (z.B. Bus-Shunt-Widerstandsabriss) detektiert werden können.

In einer weiteren Variante der Vorrichtung weist diese eine Detektionsvorrichtung (DET) auf, die interne Signale (ds1, ds3) des Busknotens (SLx) auf Plausibilität prüft. Hier sei auf die Beschreibung der Figuren verwiesen.

Schließlich können auch weitere Überprüfungen bezüglich der Ordnungsmäßigkeit des Datenbussystems vorgenommen werden, wie es z. B. in WO-A-2005/050924 beschrieben ist.

Der Busknoten (SLx) oder eine Teilvorrichtung (DET) des Busknotens (Slx) ist dabei bevorzugt so gestaltet, dass er Maßnahmen ergreift, wenn die Detektionsvorrichtung (DET) nicht plausible interne Signale innerhalb des Busknotens feststellt. Hier sei auf die folgende Beschreibung der Figuren bezüglich möglicher Maßnahmen verwiesen.

Beispielsweise weist ein erfindungsgemäßer Busknoten eine Teilvorrichtung (MUX) aufweist, die den Einspeisepunkt des Adressierungsstromes der Adressierungsstromquelle (Iqx) ändern kann. Alternativ statt einer Adressierungsstromquelle (Iqx) und eines Multiplexers (MUX) kann ein erfindungsgemäßer Busknoten (SLx) auch eine erste Adressierungsstromquelle (Iqx1) und eine zweite Adressierungsstromquelle (Iqx2) aufweisen, wobei die erste Adressierungsstromquelle (Iqx1) ihren Strom in einen mit dem ersten Anschluss des Bus-Shunt-Widerstands (R2) verbundenen Knoten einspeist, wenn sie Strom einspeist, und wobei die zweite Adressierungsstromquelle (Iqx2) ihren Strom in einen mit dem zweiten Anschluss des Bus-Shunt-Widerstands (R2) verbundenen Knoten einspeist, wenn sie Strom einspeist. Um die Autoadressierung zu ermöglichen speist nur eine der beiden Adressierungsstromquellen (Iqxl, Iqx2) den Autoadressierungsstrom ein, während die jeweils andere bevorzugt keinen Strom einspeist. Bevorzugt speisen also die beiden Adressierungsstromquellen (Iqxl, Iqx2) ihre Ströme so ein, dass der Adressierungsstrom den Bus-Shunt-Widerstand (R2) vorzugsweise in Richtung zum Bus-Master (ECU) durchströmt.

In einer weiteren besonders bevorzugten Variante des Autoadressier-Busknotens erhöht die den Adressierungsstrom einspeisende Adressierungsstromquelle (Iql, Iq2, Iq2) den Adressierungsstrom mit einer ersten Zeitkonstante (τ₁) und erniedrigt ihn mit einer zweiten Zeitkonstante (τ₂), die kleiner oder größer als die erste Zeitkonstante (τ₁) ist.

Zur Verbesserung der EMV-Fähigkeit wird vorgeschlagen, ein Verfahren zur Vergabe von Busknotenadressen innerhalb eines seriellen Datenbusses mit einer Kette von Busknoten (SL1, SL2, SL3) und einem Busmaster (ECU) wie z.B. oben beschrieben auszuführen. Das folgende Prinzip zur Verbesserung des EMV-Verhaltens kann aber auch auf Autoadressierungsmetoden angewandt werden, wie sie beispielsweise in den Schriften DE-B-10 256 631, EP-B-1 603 282, US-B-7 590 140, EP-B-1 490 772 und EP-B-1 298 851 bekannt sind.

Dabei können die Busknoten (SL1, SL2, SL3) Autoadressier-Busknoten oder Standard-Busknoten sein. Der Datenbus weist einen Busmaster (ECU) auf. Jeder Busknoten (SL2, SL3) weist einen vorausgehenden Busknoten (SL1, SL2) auf, wenn er nicht der erste Busknoten (SL1) ist. Jeder Busknoten (SL2, SL3) ist mit seinem vorausgehenden Busknoten (SL1, SL2) durch den Datenbus verbunden, wenn er nicht der erste Busknoten (SL1) ist. Der erste Busknoten (SL1) ist mit dem Busmaster (ECU) durch den Datenbus verbunden. Jeder Busknoten (SL2, SL3) sendet einen Busknotenausgangsstrom (i2, i3) an seinen vorausgehenden Busknoten (SL1, Sl2) über einen Busknoten-Ausgang, wenn er nicht der erste Busknoten (SL1) ist. Der erste Busknoten (SL1,) sendet einen Busknotenausgangsstrom (i1) an den Busmaster (ECU) über einen Busknoten-Ausgang. Jeder Busknoten (SL1, SL2) empfängt einen Busknoteneingangsstrom (i2, i3) von seinen nachfolgenden Busknoten (SL2, Sl3) über einen Busknoten Eingang, wenn er nicht der letzte Busknoten (SL3) ist.

Das Verfahren zur Vergabe von Busknotenadressen innerhalb eines seriellen Datenbusses aus einer Kette von Busknoten (SL1, SL2, SL3) und einem Busmaster (ECU) umfasst dann erfindungsgemäß folgende Schritte:
- Einfügen eines zugeordneten Bus-Shunt-Widerstands (R2) je Autoadressier-Busknoten (SL1, SL2, SL3), der Teil des jeweiligen Autoadressier-Busknotens (SL1, SL2, SL3) ist, in den seriellen Datenbus, durch Öffnen eines Bus-Shunt-Überbrückungsschalters (S4) innerhalb des jeweiligen Autoadressier-Busknotens (SL1, SL2, SL3), der dem zugeordneten Bus-Shunt-Widerstand (R2) zugeordnet ist. Es ist offensichtlich, dass dieses Einfügen nur dann erfolgt, wenn der Bus-Shunt-Überbrückungsschalter (S4) des jeweiligen Bus-Shunt-Widerstands (R2) noch nicht geöffnet ist. Im Rahmen dieser Anmeldung wird davon ausgegangen, dass der jeweilige Bus-Shunt-Widerstand (R2) eines Autoadressier-Busknoten (SL1, SL2, SL3) zu Anfang der Adressierungssequenz durch den jeweiligen Bus-Shunt-Überbrückungsschalter (S4) überbrückt ist und damit aus dem Datenbus entfernt ist;
- Ermittlung und Vergabe einer Busknotenadresse für zumindest einen der Autoadressier-Busknoten (SL1, SL2, SL3), dem neuadressierten Autoadressier-Busknoten (SL1, SL2, SL3), unter Zuhilfenahme der nicht durch ihren zugeordneten Bus-Shunt-Überbrückungsschalter (S4) überbrückten, zugeordneten Bus-Shunt-Widerstände (R2);
- Überbrücken des zugeordneten Bus-Shunt-Widerstands (R2) des neuadressierten Autoadressier-Busknoten (SL1, SL2, SL3) durch Schließen des dem zugeordneten Bus-Shunt-Widerstand (R2) des neuadressierten Autoadressier-Busknoten (SL1, SL2, SL3) zugeordneten Bus-Shunt-Überbrückungsschalters (S4), wobei sich der neuadressierten Autoadressier-Busknoten (SL1, SL2, SL3) wie nach der Vergabe der Busknotenadresse an den neuadressierten Autoadressier-Busknoten (SL1, SL2, SL3) und dem Schließen seines zugeordneten Bus-Shunt-Überbrückungsschalter (S4) wie ein Standard-Busknoten bist zu einem Ereignis verhält, dass dieses Verhalten des neuadressierten Autoadressier-Busknoten (SL1, SL2, SL3) aufhebt. Ein solches Ereignis kann beispielsweise ein Broadcast-Kommando an alle Autoadressier-Busknoten sein, diese Bus-Shunt-Überbrückungsschalter (S4) zu öffnen oder ein Reset des Bussystems oder ein Spannungseinbruch der Versorgungsspannung. Bevorzugt führt ein Öffnen des Bus-Shunt-Überbrückungsschalters (S4) zu einem Ungültigwerden der vergebenen Busknotenadresse des betreffenden Autoadressier-Busknotens (SL1, SL2, SL3);
- Ggf. Wiederholung der Ermittlung und Vergabe einer Busknotenadresse für zumindest einen weiteren der Autoadressier-Busknoten (SL1, SL2, SL3) und ggf. Überbrücken des zugeordneten Bus-Shunt-Widerstands (R2) des weiteren neuadressierten Autoadressier-Busknoten (SL1, SL2, SL3) mittels des zugeordneten Bus-Shunt-Überbrückungsschalter (S4) bis ggf. alle Autoadressier-Busknoten (SL1, SL2, SL3) eine Busknotenadresse erhalten haben. Natürlich kann dieser Prozess auch abgebrochen werden, ohne dass alle Autoadressier-Busknoten (SL1, SL2, SL3) eine Busknotenadresse erhalten haben. Dies dürfte in der Regel aber nicht sinnvoll sein;

Um das zuvor beschriebene Verfahren durchführen zu können, wird ein erfindungsgemäßer Busknoten vorgeschlagen, der zur Durchführung eines Verfahrens zur Vergabe von Busknotenadressen an Busknoten eines seriellen Datenbussystems in der Lage ist, wobei das Verfahren zur Vergabe von Busknotenadressen an Busknoten eines seriellen Datenbussystems mit Hilfe von Bus-Shunt-Widerständen (R2) in den einzelnen Busknoten (SL1, SL2, SL3) in einem Vergabezeitraum durchgeführt wird und wobei sich nach der Verfahren zur Vergabe von Busknotenadressen an die Busknoten des seriellen Datenbussystems in dem Vergabezeitraum ein Betriebszeitraum anschließt . Der Busknoten weist zu diesem Zweck einen solchen Bus-Shunt-Widerstand (R2) auf. Erfindungsgemäße weist er einen Bus-Shunt-Überbrückungsschalter (S4) auf, der vor Vergabe einer Busknotenadresse an den Busknoten im Vergabezeitraum geöffnet ist und der nach Vergabe einer Busknotenadresse an den Busknoten im Vergabezeitraum geschlossen ist und der in dem Betriebszeitraum geschlossen ist.

### Vorteil der Erfindung

Das vorgeschlagene Verfahren und der vorgeschlagene Busknoten ermöglichen eine Autoadressierung nach einem der vorbenannten Verfahren (bus-shunt-method = BSM-Autoadressierung), wie sie beispielsweise in den Schriften DE 10 256 631 B4, EP 1 603 282 B1, US 7 590 140 B2, EP 1 490 772 B1, EP 1 298 851 B1 und der noch unveröffentlichten deutschen Patentanmeldungen DE 10 2017 122 364.9 offenbart sind. Durch den Shunt-Überbrückungsschalter (S4) wird der Widerstand im Normalbetrieb nach durchgeführter Autoadressierung auf ein Minimum reduziert, während im Adressierungsbetrieb der Widerstandswert eine gute und robuste Autoadressierung ermöglicht.

Vorteile sind hierauf aber nicht beschränkt.

### Liste der Figuren

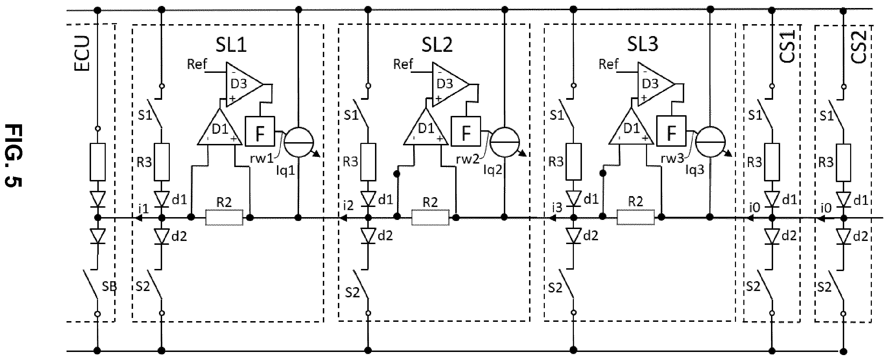

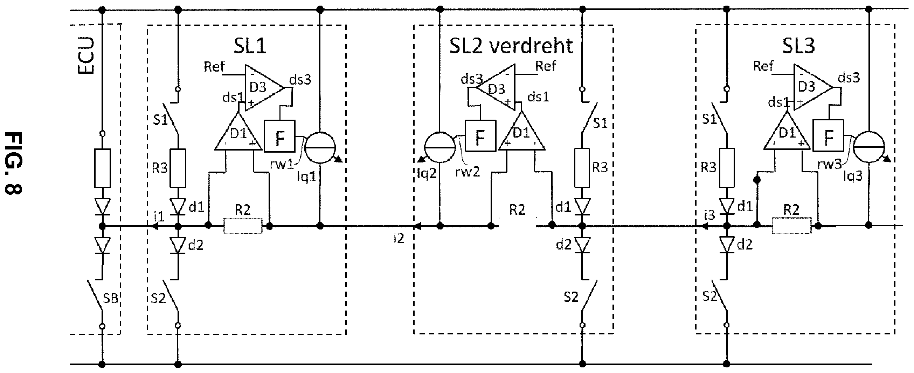

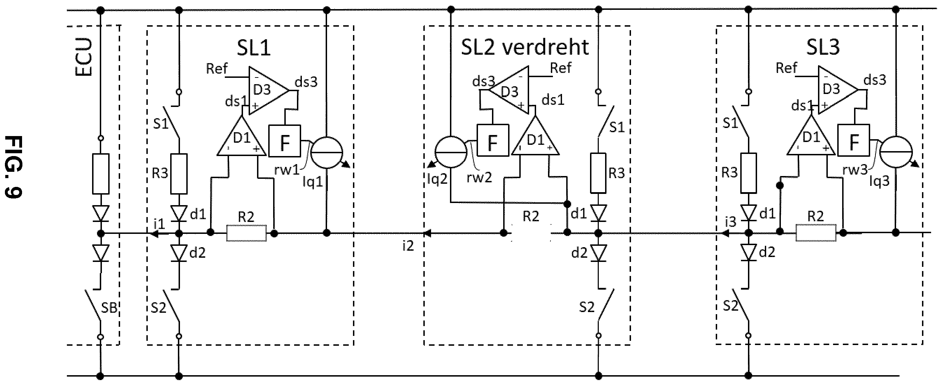

Fig. 1
   zeigt vereinfacht, schematisch ein erfindungsgemäßes Bussystem, wobei die Messung des Summenstroms durch die Messung des Summenstroms an einem Shunt-Widerstand im Busausgang des jeweiligen Autoadressier-Busknotens (SL1, SL2, Sl3) erfolgt,
Fign. 2 bis 4
   zeigen den Verlauf der Ausgangsströme (i1, i2, i3) der Busknoten (SL1, SL2, Sl3) und der Ströme der Adressierungsstromquellen (Iql, Iq2, Iq3) für verschiedene Zeitkonstanten der Regelung,
Fig. 5
   zeigt schematisch vereinfacht ein Bussystem der Kategorie A mit zwei Standard-Busknoten (CS1, CS2), die keine Autoadressierungsfähigkeit besitzen,
Fig. 6
   zeigt schematisch vereinfacht ein Bussystem der Kategorie B mit zwei Standard-Busknoten (CS1, CS2), die keine Autoadressierungsfähigkeit besitzen,
Fig. 7
   zeigt schematisch vereinfacht ein Bussystem der Kategorie C mit zwei Standard-Busknoten (CS1, CS2), die keine Autoadressierungsfähigkeit besitzen,
Fig. 8
   zeigt den Fall der Invertierung des zweiten Busknotens (SL2),
Fig. 9
   zeigt die Situation der Figur 8 nach dem Erkennen einer Vertauschung der LIN-Ein- und Ausgänge und Durchführung von Gegenmaßnamen,
Fig. 10
   zeigt den zweiten Autoadressier-Busknoten (SL2) der Fign. 8 und 9 in detaillierter Form nun als x-ten Autoadressier-Busknoten (SLx),
Fig. 11
   zeigt den zweiten Autoadressier-Busknoten (SL2) der Fign. 8 und 9 in detaillierter Form nun als x-ten Autoadressier-Busknoten (SLx), und zwar in dem Zustand des Anschlusses an den Bus in der ersten von zwei Möglichkeiten,
Fig. 12
   entspricht der Fig. 5 und zeigt schematisch vereinfacht ein Bussystem der Kategorie A mit zwei Standard-Busknoten (CS1, CS2), die keine Autoadressierungsfähigkeit besitzen und Autoadressier-Busknoten (SL1, SL2, SL3) mit je einem Bus-Shunt-Überbrückungsschalter (S4) und einem Empfänger (Rec), und
Fig. 13
   einen Busknoten mit angeschlossener Applikation.

### Beschreibung der Figuren

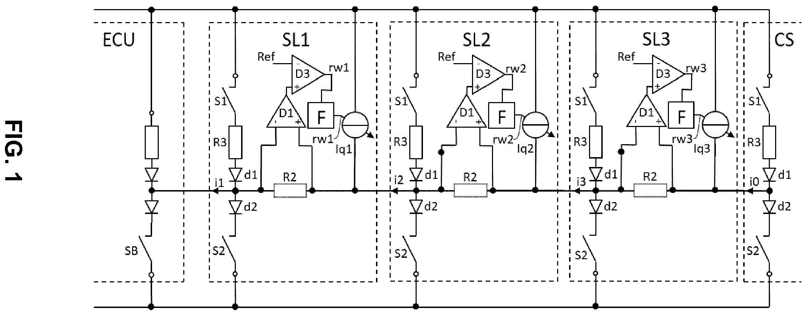

Fig. 1 zeigt vereinfacht und schematisch ein erfindungsgemäßes Bussystem.

Zu Beginn der Autoadressierung signalisiert der Busmaster (ECU) an alle Autoadressier-Busknoten, dass die Busknotenadressen vergeben werden sollen. Die folgende Adressvergabe ist in Adressvergabephasen aufgespalten, wobei in jeder Adressvergabephase genau mittels eines Initialisierungsdurchlaufs bevorzugt genau ein Autoadressier-Busknoten, nämlich der letzte der Autoadressier-Busknoten (SL1, SL2, Sl3) vom Busmaster (ECU) aus in der Busknotenkette, der noch keine Busknotenadresse erhalten hat, eine gültige Busknotenadresse vom Busmaster (ECU) erhält. Bevorzugt übermittelt der Busmaster mittels eines sogenannten Broadcast-Kommandos an alle Autoadressier-Busknoten die Anzahl der Standard-Busknoten, die sich vor den Autoadressier-Busknoten (Sl1, Sl2, Sl3), also zwischen diesen und dem Busmaster (ECU) befinden oder einen maximalen Adressierungsstrompegel. Selbstverständlich kann dieser maximale Adressierungsstrompegel Iₐₘₐₓ auch den Busknoten einprogrammiert sein, da die Bus-Topologie ja typischerweise konstruktiv und nicht betriebsbedingt ist und daher vorhersagbar ist. Hierbei wird festgelegt, welcher Summenstrom (I_{ref}) durch den Bus-Shunt-Widerstand (R2) fließen soll.

Zu Beginn jeder Adressvergabephase schließt der Busmaster (ECU) seinen Schalter (SB) wieder für eine vorbestimmte Adressierungszeit T_{A}. Bei dieser Stromsenke (SB) des Busmasters (ECU) handelt es sich in der Regel in Wirklichkeit um eine komplexere Struktur, die auch einen Buskurzschluss detektieren kann und hier nur vereinfacht wiedergegeben ist. Auf diese Weise stellt der Busmaster (ECU) eine Stromsenke für den Adressierungsstrom der Autoadressierungsstromquellen und die Busknotengrundströme der Busknoten in der folgenden Adressvergabephase bereit. Die autoadressierungsfähigen Autoadressier-Busknoten (SL1), (SL2) und (SL3) registrieren, dass der Datenbus gegen Masse gezogen wird und öffnen ihre jeweiligen Schalter S1 und S2. Damit speisen die Autoadressier-Busknoten (SL1, Sl2, Sl3) keinen Busknotengrundstrom mehr in den Datenbus ein.

Nach Versteichen eines ersten Zeitraums (dt1) bestimmen die Autoadressier-Busknoten den Grundstrom durch den jeweiligen Bus-Shunt-Widerstand (R2) durch vermessen des Spannungsabfalls über diesen Bus-Shunt-Widerstand (R2). Dieser Spannungsabfall kann beispielsweise als Offset-Spannungswert in einer Sample-And-Hold-Schaltung zwischen gespeichert werden und durch eine Subtrahierer Schaltung in der Folge von dem dann später gemessenen Spannungsabfall über den Bus-Shunt-Widerstand (R2) abgezogen werden. Hierdurch wird sichergestellt, dass nur der vom jeweiligen Grundstrom abweichende Busstrom für die Adressvergabe und die Regelung der Adressierungsstromquellen (Iql, Iq2, Iq3) genutzt wird.

Diese Phase wird nach Verstreichen eines zweiten Zeitraums (dt2) beendet.

Alle Autoadressier-Busknoten, die noch keine gültige Busknotenadresse besitzen, erfassen den vom Grundstrom abweichenden Strom durch ihren jeweiligen Bus-Shunt-Widerstand (R2) und regeln auf Basis dieses so erhaltenen Busstrommesswerts nun im Anschluss daran ihre jeweilige Adressierungsstromquelle (Iql, Iq2, Iq3) so aus, dass der Strom durch ihren jeweiligen Bus-Shunt-Widerstand (R2) der zuvor ermittelten oder vorgegebenen Stromsumme (I_{ref}) entspricht. Hierzu verfügt der jeweilige Autoadressier-Busknoten über Messmittel (R2, D1, D3), um die reale Stromsumme in Form des jeweiligen Busknotenausgangsstroms (i1, i2, i3) in Richtung Busmaster (ECU) zu ermitteln. Hierbei wird der Spannungsabfall über den Bus-Shunt-Widerstand (R2) erfasst und bevorzugt nach Abzug des Spannungswerts für den Busgrundstrom als Stromsummensignal weiterverarbeitet. Wie bereits erläutert, wird das so erzeugte Stromsummensignal in einem vorzugsweise nichtlinearen Filter (F1) zu einem Regelsignal gefiltert. Dieses wird mit einem Referenzwert (Ref) durch eine Differenzverstärkerstufe verglichen, was einem Vergleich des jeweiligen Busknotenausgangsstroms (i1, i2, i3) mit einem Referenzstrom (I_{ref}) in seiner Wirkung gleichkommt. Bei der Einstellung oder Berechnung des Referenzstroms (I_{ref}) wird also in Wirklichkeit typischerweise dieser Referenzwert (Ref) festgelegt. Dieser Vergleich kann vor und nach der Filterung im Filter (F) erfolgen. Bevorzugt handelt es sich um eine Differenzbildung. Auch kann nach diesem Vergleich eine weitere Filterung erfolgen, die in den Figuren nicht eingezeichnet ist. Der so ermittelte Regelwert (rwl, rw2, rw3) steuert dann die jeweilige Adressierungsstromquelle (Iql, Iq2, Iq3) des jeweiligen Autoadressier-Busknotens (SL1, SL2, SL3).

Da die Stromsumme am Ausgang des jeweiligen Autoadressier-Busknotens (SL1, Sl2, Sl3) immer konstant sein soll, liefert schließlich nur der letzte Autoadressier-Busknoten (SL3) elektrischen Strom in den Datenbus, während alle anderen Adressierungsstromquellen (Iql, Iq2) der anderen Autoadressier-Busknoten (SL1, Sl2) durch die Regler (R2, D1, D3, F) der anderen Autoadressier-Busknoten (SL1, Sl2) herunter geregelt sind. Dies hat zur Folge, dass der Regelwert (rw3) des letzten Busknotens (SL3) sich durch die Regelwerte (rwl, rw2) der anderen Busknoten (SL1, Sl2) darin unterscheidet, dass er die Adressierungsstromquelle (Iq3) seines Busknotens (SL3) voll aufsteuert, während die Regelwerte (rwl, rw2) der vorausgehenden Busknoten (SL1, SL2) solche Werte haben, dass sie ihre Adressierungsstromquellen (Iql, Iq2) herunterregeln. Somit kann jeder Busknoten (SL1, SL2, SL3) diesen Regelwert (rwl, rw2, rw3) mit einem vorzugsweise in etwa gleichen Schwellwert (SW) vergleichen.

Diese Phase endet nach einem dritten Zeitraum (dt3).

Das Ende dieser Adressierungsphase ist bevorzugt durch das Öffnen des Stromsenkenschalters (SB) gekennzeichnet. Hierdurch wird der Datenbus wieder gegen Versorgungsspannung gebracht. Die Busknoten (SL1, SL2, SL3) frieren dann bevorzugt den Stand ihres jeweiligen Regelwerts (rwl, rw2, rw3) ein und werten ihn im Vergleich zum besagten Schwellwert (SW) aus und entscheiden dann auf dieser Basis, ob sie der letzte Autoadressier-Busknoten (hier SL3) in der Busknotenkette (SL1, SL2, SL3) sind oder ein vorausgehender Autoadressier-Busknoten (SL1, Sl2). Sind sie der letzte Busknoten (SL3), so übernehmen sie die ganz zu Beginn vom Busmaster (ECU) signalisierte, zu vergebende Busknotenadresse, die sie vorzugsweise in einem geeigneten Speicher für diesen Fall nach dem Empfang abgespeichert haben. An weiteren Adressierungsphasen in Form von Initialisierungsdurchläufen nimmt dieser Autoadressier-Busknoten (SL3) dann nicht mehr teil. Dies bedeutet, dass dieser Autoadressier-Busknoten (SL3) dann keinen Adressierungsstrom mittels seiner Adressierungsstromquelle (Iq3) mehr in den Datenbus einspeist. Selbstverständlich übernimmt er die vom Busmaster (ECU) angebotenen weiteren Busknotenadressen dann ebenso nicht mehr, da er ja über eine gültige Busknotenadresse verfügt und sich wie ein Standard-busknoten bis zum ungültig werden seiner gültigen Busknotenadresse verhalten soll. Die Busknotenadresse eines Autoadressier-Busknotens wird beispielsweise ungültig, z.B. bei einem Spannungseinbruch der Betriebsspannung unter einen Betriebsspannungsschwellwert oder beispielsweise aufgrund deines Befehls des Busmasters oder aufgrund einer anderen Signalisierung.

Bevorzugt prüft der Busmaster am Ende eines jeden Initialisierungsdurchlaufs die erfolgreiche Adressvergabe.

Es folgt dann die Adressierungsphase in Form eines folgenden Initialisierungsdurchlaufs, in der der nächste nunmehr letzte noch nicht adressierte Autoadressier-Busknoten (SL2) seine gültige Busknotenadresse auf gleiche Weise erhält. Der Ablauf erfolgt analog. An weiteren Adressierungsphasen in Form von folgenden Initialisierungsdurchläufen nimmt dieser Autoadressier-Busknoten (SL2) dann so wie der zuerst mit einer gültigen Busknotenadresse versehene Autoadressier-Busknoten (SL3) auch nicht mehr teil. Er verhält sich dann wie ein Standard-Busknoten. Dies bedeutet, dass er keinen Adressierungsstrom mittels seiner Adressierungsstromquelle (Iq2) mehr in den Datenbus einspeist. Selbstverständlich übernimmt er die vom Busmaster (ECU) angebotenen weiteren zu vergebenden Busknotenadressen dann ebenfalls nicht mehr, da er ja dann über eine gültige Busknotenadresse verfügt. Dies wird fortgesetzt, bis alle Autoadressier-Busknoten eine gültige Busknotenadresse erhalten haben.

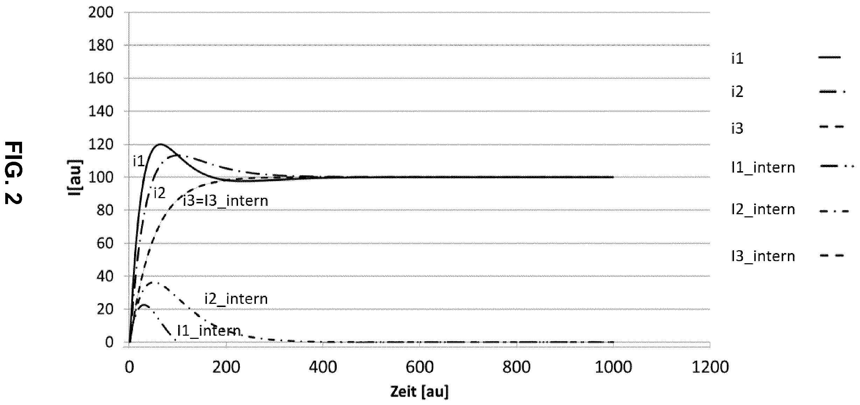

Fig. 2 zeigt den Verlauf des Ausgangsstroms (i1) des ersten Busknotens (SL1), des Ausgangsstroms (i2) des zweiten Busknotens (SL2) und des Ausgangsstroms (i3) des dritten Busknotens (SL3). Außerdem zeigt sie den Strom (I1_intern) der Adressierungsstromquelle (Iq1) des ersten Busknotens (SL1), den Strom (I2_intern) der Adressierungsstromquelle (Iq2) des zweiten Busknotens (SL2) und den Strom (I3_intern) der Adressierungsstromquelle (Iq3) des dritten Busknotens (SL3). Hier sind die Zeitkonstanten für Heraufregelung der Adressierungsstromquellen und Herunterregelung der Adressierungsstromquellen in etwa gleich. Es kommt zu einem Überschwinger. Gut zu erkennen ist, dass der Strom (I1_intern) der Adressierungsstromquelle (Iq1) des ersten Busknotens (SL1) und der Strom (I2_intern) der Adressierungsstromquelle (Iq2) des zweiten Busknotens (SL2) von den Reglern dieser Autoadressier-Busknoten herunter geregelt werden, während der Strom (I3_intern) der Adressierungsstromquelle (Iq3) des dritten Busknotens (SL3) auf den Referenzwert geregelt wird. Die Zeit zum Einschwingen wird anders als in der DE-B-10 2010 026 431 nur durch die erste Zeitkonstante (τ₁) bestimmt.

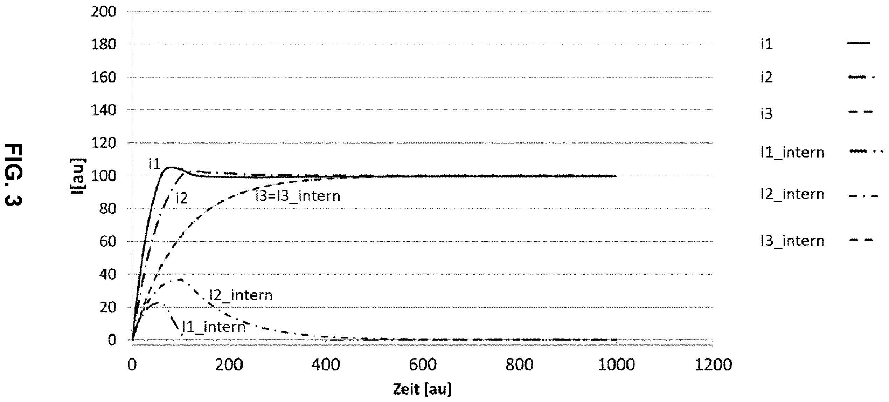

Fig. 3 zeigt den Verlauf des Ausgangsstroms (i1) des ersten Busknotens (SL1), des Ausgangsstroms (i2) des zweiten Busknotens (SL2) und des Ausgangsstroms (i3) des dritten Busknotens (SL3). Außerdem zeigt sie den Strom (I1_intern) der Adressierungsstromquelle (Iq1) des ersten Busknotens (SL1), den Strom (I2_intern) der Adressierungsstromquelle (Iq2) des zweiten Busknotens (SL2) und den Strom (I3_intern) der Adressierungsstromquelle (Iq3) des dritten Busknotens (SL3). Hier sind die Zeitkonstanten für Heraufregelung der Adressierungsstromquellen in etwa zehnmal so lang wie die Zeitkonstanten für die Herunterregelung der Adressierungsstromquellen. Es kommt zu einem minimalen Überschwinger.

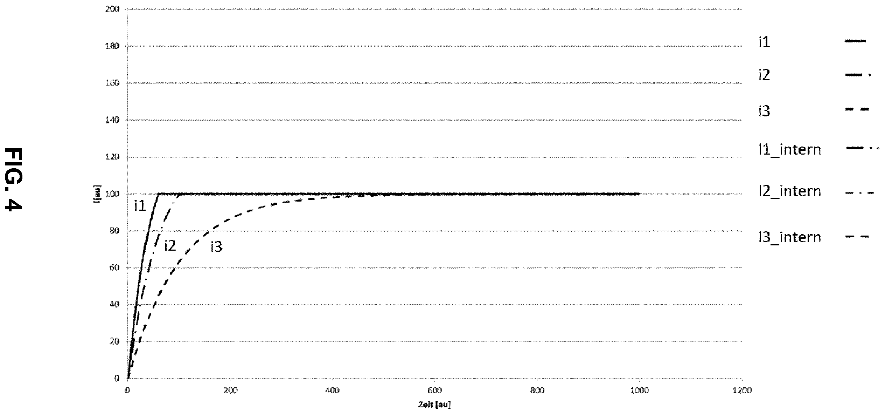

Fig. 4 zeigt den Verlauf des Ausgangsstroms (i1) des ersten Busknotens (SL1), des Ausgangsstroms (i2) des zweiten Busknotens (SL2) und des Ausgangsstroms (i3) des dritten Busknotens (SL3). Außerdem zeigt sie den Strom (I1_intern) der Adressierungsstromquelle (Iq1) des ersten Busknotens (SL1), den Strom (I2_intern) der Adressierungsstromquelle (Iq2) des zweiten Busknotens (SL2) und den Strom (I3_intern) der Adressierungsstromquelle (Iq3) des dritten Busknotens (SL3). Hier sind die Zeitkonstanten für Heraufregelung der Adressierungsstromquellen in etwa hundertmal so lang wie die Zeitkonstanten für die Herunterregelung der Adressierungsstromquellen. Es kommt zu keinem Überschwinger.

Fig. 5 zeigt schematisch vereinfacht ein Bussystem der Kategorie A mit zwei Standard-Busknoten (CS1, CS2), die keine Autoadressierungsfähigkeit besitzen.

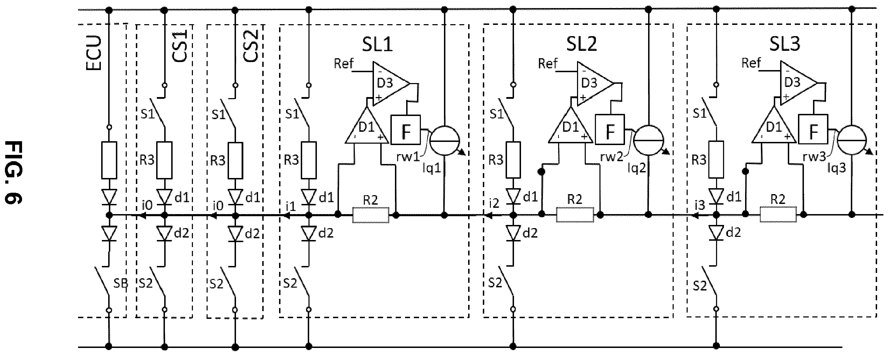

Fig. 6 zeigt schematisch vereinfacht ein Bussystem der Kategorie B mit zwei Standard-Busknoten (CS1, CS2), die keine Autoadressierungsfähigkeit besitzen.

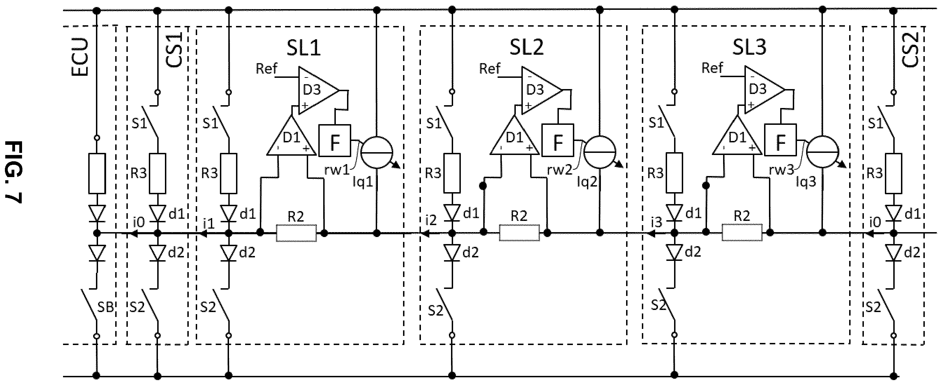

Fig. 7 zeigt schematisch vereinfacht ein Bussystem der Kategorie C mit zwei Standard-Busknoten (CS1, CS2), die keine Autoadressierungsfähigkeit besitzen.

Fig. 8 zeigt den Fall der Verdrehung des zweiten Busknotens (SL2). Bei dem zweiten Busknoten (SL2) sind in diesem Beispiel der LIN-Bus-Eingang und der LIN-Bus-Ausgang vertauscht. Dieser Betriebsfall soll erkannt werden. Die Vertauschung hat zur Folge, dass der Bus-Shunt-Strom (i2R) durch den Bus-Shunt Widerstand (R2) dieses verdrehten zweiten Busknotens (SL2), in dessen Bus-Shunt Widerstand (R2) rückwärts im Vergleich zur Normallage eingespeist wird. Dieser Bus-Shunt-Strom (i2R) durch den Bus-Shunt Widerstand (R2) umfasst in diesem Beispiel nur den Busknotenausgangsstrom (i3) des nachfolgenden, dritten Autoadressier-Busknotens (SL3) bzw. in anderen Fällen der nachfolgenden Busknoten. Dieser Busknotenausgangsstrom (i3) des dritten Autoadressier-Busknotens (SL3) führt also nun zu einem negativen Spannungsabfall (V_{R2}) über den Bus-Shunt-Widerstand (R2). Dies kann von dem ersten Differenzverstärker (D1) des verdrehten zweiten Autoadressier-Busknotens (SL2) in diesem Beispiel erkannt werden. Dessen Ausgang (ds1) saturiert infolge der negativen Ansteuerung durch den negativen Spannungsabfall (V_{R2}) über den Bus-Shunt-Widerstand (R2) bei dem kleinsten möglichen Ausgangspegel des Ausgangs (ds1) des Differenzverstärkers (D1). Dieser kleinste mögliche Ausgangspegel des Ausgangs (ds1) des Differenzverstärkers (D1) kann ein betragsmäßiger Maximalwert eines negativen Ausgangswerts oder ein betragsmäßiger Minimalwert eines positiven Ausgangswerts sein. Typischerweise liegt dies je nach Konstruktion des ersten Differenzverstärkers (D1) und seiner Spannungsversorgung in der Nähe von 0V. Damit liegt der Ausgang (ds1) des ersten Differenzverstärkers (D1) typischerweise unter dem Pegel des Referenzwerts (Ref). Dies verursacht ein großes positives Signal am Ausgang (ds3) des dritten Differenzverstärkers (D3) und damit zumindest nach dem Einschwingen des nichtlinearen Filters (F) des verdrehten Autoadressier-Busknotens (SL2) eine Maximierung des Adressierungsstroms durch die geregelte Adressierungsstromquelle (iq2) des zweiten, hier in diesem beispielhaften Fehlerfall verdrehten Autoadressier-Busknotens (SL2). Somit erhöht der Regelkreis den Adressierungsstrom, der durch die Adressierungsstromquelle (Iq2) in den Datenbus eingespeist wird. Hierbei entsteht nun das Problem, dass dieser Adressierungsstrom nicht wie vorgesehen durch den eigenen Bus-Shunt-Widerstand (R2) fließt. Somit ist der vorgesehene Regelkreis unterbrochen. Die Stromtransiente durch den Busknotenausgangsstrom (i3) des nachfolgenden dritten Autoadressier-Busknotens (SL3) bewirkt daher nicht wie vorgesehen eine positive Stromtransiente im Bus-Shunt-Widerstand (R2), sondern eine negative Stromtransiente. Weitere hinter dem zweiten verdrehten Autoadressier-Busknoten (SL2) liegende Autoadressier-Busknoten (SL2) würden den Spannungsabfall über den Bus-Shunt-Widerstand (R2) des zweiten verdrehten Autoadressier-Busknotens (SL2) weiter negativ vorspannen.

Der verdrehte zweite Autoadressier-Busknoten (SL2) kann jedoch anhand des Spannungsabfalls (V_{R2}) über seinen Bus-Shunt-Widerstand (R2), der den Spannungsbetrag von |V_{R2}=|i2R|^{∗}|R2| hat, erkennen, dass ein Missverhältnis zwischen der durch seine geregelte Adressierungsstromquelle (Iq2) erzeugte Transiente des Adressierungsstroms und der im Normalfall korrelierenden Transiente des Spannungsabfalls (V_{R2}) über seinen Bus-Shunt-Widerstand (R2) besteht. Außerdem liegt dann ein Vorzeichenfehler vor. Erfasst ein x-ter Autoadressier-Busknoten (SLx) an einer x-ten Position in der Kette der Busknoten also einen negativen Spannungsabfall (V_{R2}) über seinen Bus-Shunt-Widerstand (R2) und sollte seine Adressierungsstromquelle (Iq2) einen positiven Strom liefern, so kann der betreffende Autoadressier-Busknoten (SL2) diese Konstellation erkennen und Gegenmaßnahmen einleiten.

Insbesondere muss der betreffende x-te Autoadressier-Busknoten (SLx) verhindern, dass in diesem Fehlerfalle der Adressierungsstrom seiner geregelte Adressierungsstromquelle (Iqx) und damit der Busknotenausgangsstrom (ix) des betreffenden x-ten Autoadressier-Busknotens (SLx) weiter steigt, da der Busknotenausgangsstrom (ix), der die Summe des Buseingangsstroms und des Adressierungsstrom seiner geregelte Adressierungsstromquelle (Iqx) ist, den maximalen LIN-Busstrom überschreiten würde (Bedingung: i1= < 40mA).

Im einfachsten Fall schaltet der x-te Autoadressier-Busknoten (SLx) seine Adressierungsstromquelle (Iqx) ab und übernimmt eine vorherbestimmte Fehleradresse als Busknotenadresse. Der Busmaster (ECU) kann nach erfolgter Autoadressierung eine Testabfrage der Busknoten mit dieser Fehleradresse als Busknotenadresse senden, worauf diese mit einer standardisierten Antwort antworten.

Der Busmaster (ECU) kann dann im einfachsten Fall einen Busfehler an alle Busknoten und/oder Nutzer signalisieren. Der Busmaster (ECU) kann aber auch einen Befehl an die Busknoten mit dieser Fehleradresse absetzen, woraufhin diese zum Ersten den Einspeisepunkt Ihres Adressierungsstromes z.B. durch einen Multiplexer (MUX) ändern und zum Zweiten die Polarität der Eingänge oder alternativ des Ausgangs des ersten Differenzverstärkers (D1) tauschen. Der Bus-Master (ECU) führt dann eine erneute Adressvergabe durch. Erst wenn diese immer noch fehlerhaft ist, signalisiert er bevorzugt einen Fehler. Ggf. schaltet er die dann immer noch betroffenen Busknoten per Befehl (Broadcast-Befehl) an die besagte Fehleradresse ab, da dann offensichtlich ein anderer Fehler vorliegt.

Fig. 9 zeigt die Situation nach
a. dem Erkennen einer Vertauschung der LIN-Ein- und Ausgänge,
b. dem Umschalten des Einspeisepunkts des Autoadressierungsstroms der Adressierungsstromquelle (Iq2) des hier beispielhaft verdrehten zweiten Autoadressier-Busknotens (SL2) und
c. dem Vertauschen der Polarität der Eingänge oder dem alternativen Vertauschen des Ausgangs des ersten Differenzverstärkers (D1).

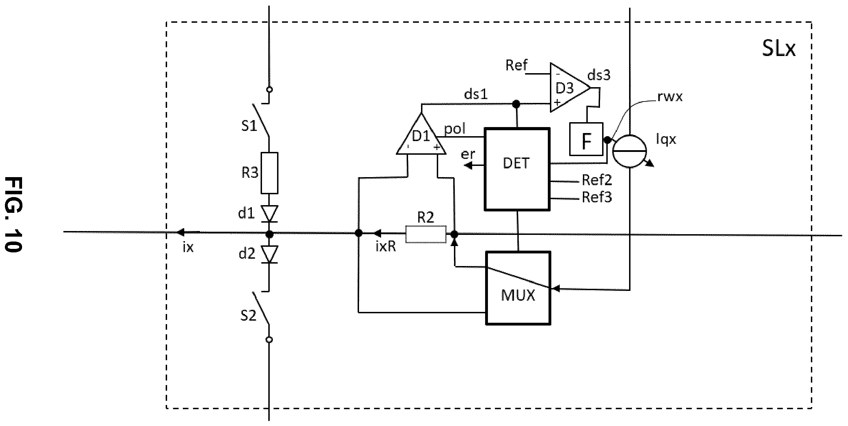

Fig. 10 zeigt den zweiten Autoadressier-Busknoten (SL2), der Fign. 8 und 9 in detaillierter Form nun als x-ten Autoadressier-Busknoten. Hierbei steht x für eine Position in der LIN-Bus-Kette der Busknoten in Form einer positiven, ganzen, natürlichen Zahl. Es handelt sich um einen x-ten Autoadressier-Busknoten (SLx) der in der Lage ist,
- zum Ersten eine Vertauschung seines LIN-Eingangs mit seinem LIN-Ausgang zu erkennen und
- zum Zweiten in diesem Fall als beispielhafte Gegenmaßnahme den Einspeisepunkt für den Adressierungsstrom seiner geregelten Adressierungsstromquelle (Iqx) so vor oder hinter seinem Bus-Shunt Widerstand (R2) zu positionieren, dass die Autoadressierung je nach der Ausrichtung, der der Busknoten angeschlossen ist, möglich ist.

Hierzu weist der in Fig. 10 beispielhaft dargestellte x-te Autoadressier-Busknoten (SLx) eine Detektionsvorrichtung (DET) auf, die in der Lage ist, eine Vertauschung des LIN-Eingangs des x-ten Autoadressier-Busknotens (SLx) mit dem LIN-Ausgang des x-ten Autoadressier-Busknotens (SLx) festzustellen. Hierzu überprüft die beispielhafte Detektionsvorrichtung (DET) interne Signale des x-ten Autoadressier-Busknoten (SLx) auf Plausibilität. Lassen die internen Signale des x-ten Autoadressier-Busknotens (SLx) auf eine Vertauschung des LIN-Eingangs des x-ten Autoadressier-Busknotens (SLx) mit dem LIN-Ausgang des x-ten Autoadressier-Busknotens (SLx) sicher schließen, so kann die Detektionsvorrichtung verschiedene beispielhafte Maßnahmen potenziell ergreifen.
a. Signalisierung des Fehlers an einen Nutzer;
b. Signalisierung des Fehlers an einen Bus-Master (ECU) mittels Antwort auf eine Diagnoseanfrage (Broadcast-Message);
c. Verwendung einer Fehleradresse als Busknotenadresse;
d. Umkonfiguration der internen Topologie zur Neutralisation des Fehlers;
e. Umparametrierung interner Teilvorrichtungen wie z.B. Stromquellen zur Neutralisation des Fehlers;

Weitere Maßnahmen sind denkbar.

In dem Beispiel der Fig. 10 ist eine Umkonfiguration der internen Topologie zur Neutralisation des Fehlers vorgesehen. In der Fig. 10 ändert beispielhaft die Detektionsvorrichtung (DET) den Einspeisepunkt für den Adressierungsstrom der geregelten Adressierungsstromquelle (Iqx) des x-ten Autoadressier-Busknotens (SLx) beispielsweise mit Hilfe eines analogen Multiplexers (MUX) und vertauscht die Polarität der Eingänge oder des Ausgangs des ersten Differenzverstärkers (D1) mittels des Polaritätssignals (pol).

Alternativ zu dem Beispiel der Fig. 10 ist eine Umparametrierung interner Teilvorrichtungen wie z.B. Stromquellen zur Neutralisation des Fehlers möglich wenn statt einer Adressierungsstromquelle (Iqx) des x-ten Autoadressier-Busknotens (SLx) und einem Multiplexer (MUX) eine erste Adressierungsstromquelle (Iqx1) des x-ten Autoadressier-Busknotens (SLx) und beispielsweise eine zweite Adressierungsstromquelle (Iqx2) des x-ten Autoadressier-Busknotens (SLx) verwendet werden, von denen die erste Adressierungsstromquelle (Iqx1) des x-ten Autoadressier-Busknotens (SLx) ihren Adressierungsstrom vor dem Bus-Shunt-Widerstand (R2) einspeist und die zweite Adressierungsstromquelle (Iqx2) des x-ten Autoadressier-Busknotens (SLx) ihren Adressierungsstrom hinter dem Bus-Shunt-Widerstand (R2) einspeist. In dem Fall würde die Detektionsvorrichtung (DET) den Adressierungsstrom einer der beiden Stromquellen (Iqxl, Iqx2) zu null setzen, so dass der äquivalente Effekt wie bei der Kombination einer Adressierungsstromquelle (Iqx) des x-ten Autoadressier-Busknotens (SLx) mit der Umschaltung durch einem Multiplexer (MUX) erzielt wird.

Beispielsweise kann die Detektionsvorrichtung (DET) erkennen, dass der Regelwert (rwx) des x-ten Autoadressier-Busknotens (SLx) den Adressierungsstrom der Adressierungsstromquelle (iqx) maximiert. Dies kann beispielsweise bei geeigneter Konstruktion durch Vergleich des Regelwerts (rwx) mit einem zweiten Schwellwert (Ref2) geschehen. Ist die Ableitung des Adressierungsstromes der Autoadressierungsstromquelle (iqx) nach dem Regelwert (rwx) positiv, so bedeutet dies, dass der Regelwert (rwx) oberhalb des zweiten Schwellwerts (Ref2) liegt. Des Weiteren kann die Detektionsvorrichtung (DET) gleichzeitig den Ausgang (ds1) des ersten Differenzverstärkers (D1) mit einem dritten Referenzwert vergleichen. Liegt der Ausgang (ds1) des ersten Differenzverstärkers (D1) unterhalb eines dritten Referenzwerts (Ref3), so kann die Detektionsvorrichtung auf einen negativen Spannungsabfall (V_{R2}) über den Bus-Shunt-Widerstand (R2) schließen oder auf einen Spannungsabfall (V_{R2}) über den Bus-Shunt-Widerstand (R2) nahe Null schließen. Dieser Zustand ist illegal, da die Autoadressierungsstromquelle ja einen positiven Adressierungsstrom liefert, der bei korrekter Montage durch den Bus-Shunt-Widerstand (R2) fließen müsste, was aber offensichtlich nicht geschieht.

Einen solchen erkannten Fehler kann die Detektionsvorrichtung (DET) beispielsweise über ein Fehlersignal (er) an einen Busknoten internen Rechner oder eine geeignete Steuerung signalisieren.

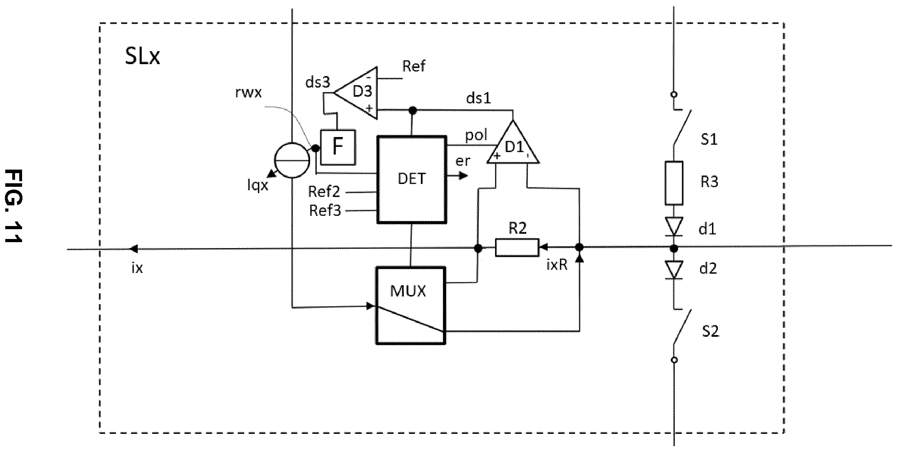

Fig. 11 zeigt die Verschaltung der Hardware für die Ansteuerung der Autoadressierungsstromquelle (Iqx) und die Einspeisung des Autoadressierungsstroms in den Datenbus, wenn der Busknoten (SLx) gegenüber der Verschaltung gemäß Fig. 10 "verdreht" in den Datenbus eingebunden ist. Durch entsprechende Ansteuerung des Multiplexers (MUX) wird nun wiederum der Adressierungsstrom, bezogen auf den Busmaster (ECU) hinter dem Bus-Shunt-Widerstand (R2) eingespeist.

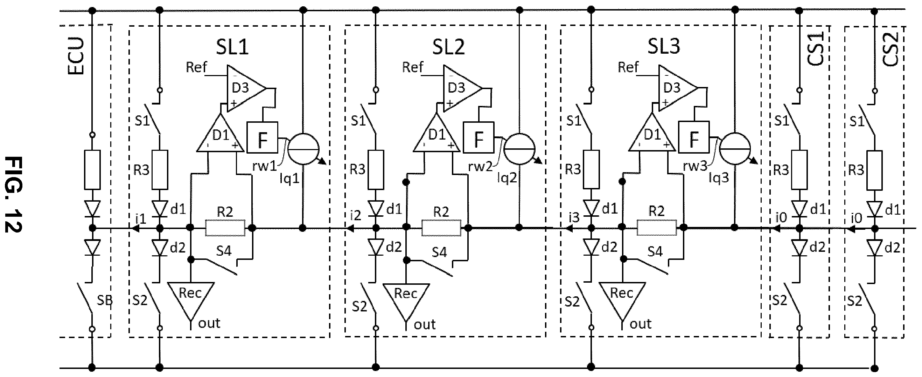

Fig. 12 entspricht der Fig. 5 und zeigt schematisch vereinfacht ein Bussystem der Kategorie A mit zwei Standard-Busknoten (CS1, CS2), die keine Autoadressierungsfähigkeit besitzen und Autoadressier-Busknoten (SL1, SL2, SL3) mit je einem Bus-Shunt-Überbrückungsschalter (S4) und einem Empfänger (Rec). Der Empfänger (Rec) wurde in den anderen Fign. 1, 5, 6, 7, 8 und 9 nur der besseren Übersicht wegen nicht eingezeichnet. Typischerweise verfügt jeder Autoadressier-Busknoten (SL1, SL2, SL3) über eine Steuerung, die mit dem Ausgang des Empfängers (Rec) verbunden ist und die typischerweise Befehle über den Datenbus empfangen kann. Durch solche Befehle kann diese Steuerung, die nicht eingezeichnet ist, vorzugsweise den Bus-Shunt-Überbrückungsschalter (S4) schließen oder öffnen. Es ist aber nicht zwingend notwendig, solche Bus-Master-Befehle für die besagte Steuerung vorzusehen, wird aber empfohlen, um dem Bus-Master (ECU) eine volle Kontrolle über den Zustand der Bus-Shunt-Überbrückungsschalter (S4) der Autoadressier-Busknoten (SL1, SL2, Sl3) zu geben. Bevorzugt können die Bus-Master-Befehle zur Kontrolle der Bus-Shunt-Überbrückungsschalter (S4) durch den Bus-Master (ECU) per Befehl an alle Autoadressier-Busknoten (SL1, SL2, SL3) oder als ein Befehl an einen konkreten Autoadressierungsbusknoten (SL1, SL2, SL3) abgesetzt werden. In letzterem Falle ist es notwendig, dass der betroffene Autoadressier-Busknoten eine gültige Busknotenadresse besitzt. Dies kann eine zuvor zugewiesene Busknotenadresse sein oder eine vorbestimmte Default-Busknotenadresse, die dann typischerweise allen noch solchen Autoadressier-Busknoten (SL1, SL2, SL3), gemeinsam ist, denen noch keine Busknotenadresse zugewiesen wurde. Somit ist es auch denkbar, dass der Bus-Master (ECU) einen Befehl zur Steuerung der Bus-Shunt-Überbrückungsschalter (S4) nur an diejenigen Autoadressier-Busknoten (SL1, SL2, SL3), die noch über keine zugewiesene Busknotenadresse verfügen, absetzt. Für das Datenbussystem kann die Zeit nach dem Einschalten in zwei grundlegende Zeitabschnitte aufgeteilt werden:
- Einen Vergabezeitraum, in dem die Autoadressier-Busknoten (SL1, SL2, SL3) durch eines der zuvor genannten oder das zuvor beschriebene Autoadressierungsverfahren einen Busknotenadresse zugewiesen bekommen, und
- einen Betriebszeitraum, in dem der Datenbus normal betrieben wird, alle Busknoten einschließlich der Autoadressier-Busknoten (SL1, SL2, SL3) eine bevorzugt gültige und bevorzugt individuelle Busknotenadresse besitzen und in dem sich die Autoadressier-Busknoten (SL1, SL2, SL3) wie Standard-Busknoten (CS1, CS2) verhalten.
- Bevorzugt sind die jeweiligen Bus-Shunt-Überbrückungsschalter (S4) der Autoadressier-Busknoten (SL1, SL2, SL3) im Betriebszeitraum geschlossen. Hierdurch wird die Ähnlichkeit im elektrischen Verhalten der Autoadressier-Busknoten (SL1, SL2, SL3) im Vergleich zu den Standard-Busknoten (CS1, CS2) wesentlich verbessert, was das EMV-Verhalten verbessert. Aus dem Stand der Technik ist nämlich bekannt, dass ggf. bei Verwendung innerhalb eines KfZ ein ferrit am Buseingang und am Busausgang eines Busknotens platziert werden muss. Durch die Reduktion des Buswiderstands durch virtuellen Wegfall des Bus-Shunt-Widerstands (R2) infolge seiner Überbrückung durch den Bus-Shunt-Überbrückungsschalter (S4) im Betriebszeitraum wird eine wesentliche Verbesserung der Buseigenschaften erzielt und die Anzahl maximal möglicher Busknoten erhöht.
- Zu Beginn des Vergabezeitraums sind bevorzugt alle Bus-Shunt-Überbrückungsschalter (S4) geöffnet. Der Vergabezeitraum startet bevorzugt mit der Signalisierung des Beginns der Adressvergabe durch den Bus-Master an alle Busknoten. Insofern hängt die konkrete Art dieses Startsignals von dem verwendeten konkreten Autoadressierungsverfahren auf Basis eines Bus-Shunt-Widerstands (R2) ab. Spätestens das Startsignal des Bus-Masters (ECU) öffnet also alle Bus-Shunt-Überbrückungsschalter (S4) aller Autoadressier-Busknoten, die über einen solchen Bus-Shunt-Überbrückungsschalter (S4) verfügen. Wird einem Autoadressier-Busknoten (SL1, SL2, SL3) durch eines der bekannten Verfahren zur Autoadressierung mittels eines bus-Shunt-Widerstands (R2) eine gültige Busknotenadresse zugewiesen, so schließt dieser betreffende Autoadressier-Busknoten seinen Bus-Shunt-Überbrückungsschalter (S4) und überbrückt somit für den Rest des Vergabezeitraums und dien sich anschließenden Betriebszeitraum den zugehörigen Bus-Shunt-Widerstand (R2). Diese Überbrückung sollte bevorzugt durch ein Rücksetzen zum Einschaltzeitpunkt oder per Software-Befehl des Bus-Masters (ECU) aufgehoben werden können.

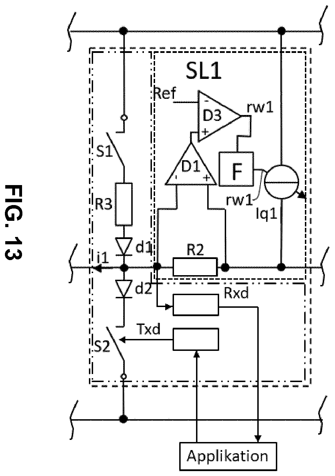

Fig. 13 zeigt einen Adressier-Busknoten (SL1), bei dem die zum Transceiver gehörenden Komponenten in strichpunktierten Linien umrandet sind. Das Signal (RxD) wird vom Bus abgezweigt und nach Verarbeitung der eigentlichen Applikation (beispielsweise einem Fensterheber oder einer Sitzverstellung) zugeführt, die ihrerseits Signale an den Transceiver sendet, die dann als Ansteuersignale (TxD) zur Steuerung des Transceivers genutzt werden. Punktiert umrandet ist derjenige Teil des Busknotens (SL1), der sich mit der Autoadressierungsmöglichkeit und der erfindungsgemäßen Einspeisung des Autoadressierungsstroms in den Datenbus befasst.

### Bezugszeichenliste

- CS1: Standard-Busknoten
- CS2: Standard-Busknoten
- D1: erster Differenzverstärker
- d1: erste Verpolschutzdiode
- D2: zweiter Differenzverstärker
- d2: zweite Verpolschutzdiode
- D3: dritter Differenzverstärker
- DET: Detektionsvorrichtung
- ds1: Ausgang des ersten Differenzverstärkers (D1)
- ds2: Ausgang des zweiten Differenzverstärkers (D2)
- ds3: Ausgang des dritten Differenzverstärkers (D3)
- ECU: Busmaster
- er: Fehlersignal an dem busknoteninternen optionalen Prozessor
- F: nichtlineares Filter eines Autoadressier-Busknotens (SL1, SL2, SL3)
- Iq1: geregelte Adressierungsstromquelle des ersten Autoadressier-Busknotens(SL1), die den Adressierungsstrom des ersten Autoadressier-Busknotens(SL1) liefert
- i1: Busknotenausgangsstrom des ersten Autoadressier-Busknotens (SL1)
- Iq2: geregelte Adressierungsstromquelle des zweiten Autoadressier-Busknotens(SL2), die den Adressierungsstrom des zweiten Autoadressier-Busknotens(SL2) liefert
- i2: Busknotenausgangsstrom des zweiten Autoadressier-Busknotens (SL2)
- i2R: Bus-Shunt-Strom durch den Bus-Shunt Widerstand (R2) des zweiten Autoadressier-Busknotens (SL2)
- Iq3: geregelte Adressierungsstromquelle des dritten Autoadressier-Busknotens(SL3), die den Adressierungsstrom des dritten Autoadressier-Busknotens(SL3) liefert
- i3: Busknotenausgangsstrom des dritten Autoadressier-Busknotens (SL3)
- Iqx: geregelte Adressierungsstromquelle des x-ten Autoadressier-Busknotens(SLx), die den Adressierungsstrom des x-ten Autoadressier-Busknotens(SLx) liefert
- ix: Busknotenausgangsstrom des x-ten Autoadressier-Busknotens (SLx)
- ixR: Bus-Shunt-Strom durch den Bus-Shunt Widerstand (R2) des x-ten Autoadressier-Busknotens (SLx)
- I_{ref}: vorgegeben Stromsumme für die Busknotenausgangsströme;
- pol: Signal mit dem die Detektionsvorrichtung (DET) die Polarität der beiden Eingänge des ersten Differenzverstärkers (D1) oder die Polarität des Ausgangs des ersten Differenzverstärkers (D1) umschaltet, wenn die Plausibilitätsprüfung nicht plausible interne Signale (ds1, ds3) ergibt.
- R1: Hilfs-Shunt Widerstand eines Autoadressier-Busknotens (SL1, SL2, SL3)
- R2: Bus-Shunt Widerstand eines Autoadressier-Busknotens (SL1, SL2, SL3)
- R3: Slave Pull-Up-Widerstand
- Rec: Empfänger
- Ref: Referenzwert
- rw1: Regelwert des ersten Autoadressier-Busknotens (SL1)
- rw2: Regelwert des zweiten Autoadressier-Busknotens (SL2)
- rw3: Regelwert des dritten Autoadressier-Busknotens (SL3)
- rwx: Regelwert des x-ten Autoadressier-Busknotens (SLX)
- S1: erster Schalter eines Autoadressier-Busknotens (SL1, SL2, SL3)
- S2: zweiter Schalter eines Autoadressier-Busknotens (SL1, SL2, SL3)
- S3: dritter Schalter eines Autoadressier-Busknotens (SL1, SL2, SL3)
- S4: Bus-Shunt-Überbrückungsschalter eines Autoadressier-Busknotens (SL1, SL2, SL3)
- SB: Schalter
- SL1: erster Autoadressier-Busknoten
- SL2: zweiter Autoadressier-Busknoten
- SL3: dritter Autoadressier-Busknoten
- SLx: x-ter Autoadressier-Busknoten
- V_{R2}: Spannungsabfall über den Bus-Shunt-Widerstand (R2) des betreffenden Autoadressier-Busknotens (SL1, SL2, SL3)

### Liste der zitierten Schriften

DE-B-10 147 512
DE-B-10 256 631
DE-B-10 2010 026 431
DE-A-196 47 668
DE-A-10 2008 044 777
EP-B-1 298 851
EP-B-1 490 772
EP-B-1 603 282
EP-A-2 571 200
EP-A-2 654 246
US-B-7 590 140
US-B-9 331 866
WO-A-2005/050924

## Patentansprüche

1. Verfahren zum Steuern eines seriellen Datenbussystems,
wobei das Datenbussystem versehen ist mit:
einer Busleitung;
einem Bus-Master, der mit der Busleitung verbunden ist; und
mehreren Busknoten, die seriell mit der Busleitung verbunden sind; wobei die mehreren Busknoten aufweisen:
mindestens zwei adressierbare Busknoten, die in einer Adressierungsphase Adressen empfangen; und
keinen oder mindestens einen Standard-Busknoten, der, ohne eine Adressierungsphase zu durchlaufen, eine bereits festgelegte Adresse hat;
wobei das Verfahren umfasst: die Adressierungsphase zum Zuweisen der Adressen zu mindestens einem der beiden adressierbaren Busknoten, und eine Betriebsphase zum Betreiben des Datenbussystems nach Beendigung der Adressierungsphase;
wobei in der Adressierungsphase mindestens zwei der mehreren Busknoten in die Busleitung einen jeweiligen Strom einspeisen, der zu dem Bus-Master fließt, und die mehreren Busknoten aufweisen:
einen ersten Busknoten, der mit der Busleitung an einer Stelle verbunden ist, die sich stromauf des Bus-Masters befindet und diesem am nächsten benachbart ist;
einen letzten Busknoten, der mit der Busleitung an einer Stelle verbunden ist, die sich stromauf des Bus-Masters befindet und am weitesten von diesem entfernt ist; und
keinen oder mindestens einen mittleren Busknoten, der mit der Busleitung zwischen dem ersten Busknoten und dem letzten Busknoten verbunden ist;
wobei:
jeder der mindestens zwei adressierbaren Busknoten eine von dem Bus-Master während der Adressierungsphase zugewiesene Adresse empfängt und eine Strommessschaltung, die mit der Busleitung verbunden ist, und einen steuerbaren Überbrückungsschalter aufweist, der parallel zu der Strommessschaltung geschaltet ist; und
jeder der Standard-Busknoten, sofern vorhanden, die jeweilige Adresse hat, die vor dem Durchführen der Adressierungsphase festgelegt wird;
wobei in dem Verfahren:
in der Adressierungsphase jedem adressierbaren Busknoten eine Adresse in einem offenen Zustand des Überbrückungsschalters zugewiesen wird, und
in der Betriebsphase die Strommessschaltung jedes adressierten adressierbaren Busknotens durch Schließen des Überbrückungsschalters umgangen wird;
**dadurch gekennzeichnet,**
**dass** bei dem Verfahren ferner,
in der Adressierungsphase jeder adressierbare Busknoten, dem während der Adressierungsphase noch keine Adresse zugewiesen worden ist, in die Busleitung einen jeweiligen Adressierungsstrom einspeist, der zu dem Bus-Master fließt, wobei der jeweilige Adressierungsstrom durch die Stromessschaltung des jeweiligen adressierbaren Busknotens fließt, dem noch keine Adresse zugewiesen worden ist.

2. Verfahren nach Anspruch 1, **dadurch gekennzeichnet, dass** die Adressierungsphase mehrere Adressierzyklen aufweist und für jeden der Adressierzyklen:
eine Adresse jeweils einem der adressierbaren Busknoten, dem noch keine Adresse zugewiesen wurde, zugewiesen wird; und,
nach dem Zuweisen der Adresse, der eine der adressierbaren Busknoten für den Rest der Adressierungsphase nicht an einer weiteren Adresszuweisung für andere noch nicht adressierte adressierbare Busknoten teilnimmt, und wobei ferner, nach dem Zuweisen der Adresse, für den einen der adressierbaren Busknoten die Strommessschaltung umgangen wird, indem der parallel zu der Strommessschaltung geschaltete Überbrückungsschalter geschlossen wird.

3. Verfahren nach Anspruch 1 oder 2, **dadurch gekennzeichnet, dass** die Strommessschaltung einen Shunt-Widerstand aufweist.

4. Adressierbarer Busknoten für ein serielles Datenbussystem,
wobei das Datenbussystem aufweist:
eine Busleitung;
einen Bus-Master, der mit der Busleitung verbunden ist; und
mehrere Busknoten, die seriell mit der Busleitung verbunden sind, wobei die mehreren Busknoten aufweisen:
mindestens zwei adressierbare Busknoten, die von dem Bus-Master in einer Adressierungsphase zugewiesene Adressen empfängt; und
keinen oder mindestens einen Standard-Busknoten, der, ohne eine Adressierungsphase zu durchlaufen, jeweils eine bereits zugewiesene Adresse hat;
wobei der adressierbare Busknoten aufweist:
eine Strommessschaltung, die mit der Busleitung verbunden ist;
einen Überbrückungsschalter, der parallel zu der Strommessschaltung geschaltet ist;
eine Adressierungsstromquelle, um in die Busleitung einen Adressierungsstrom einzuspeisen, der in den Bus-Master fließt; und
eine Ansteuereinheit zum Steuern des Überbrückungsschalters;
wobei in einer zum Zuweisen einer Adresse vorgesehenen Adressierungsphase des Datenbussystems die Ansteuereinheit den Überbrückungsschalter zum Einnehmen eines offenen Zustands steuert und in einer Betriebsphase des Datenbussystems, die nach Beendigung der Adressierungsphase erfolgt, die Ansteuereinheit den Überbrückungsschalter zum Einnehmen eines geschlossenen Zustands steuert;
wobei die Strommessschaltung den von der Adressierungsstromquelle in die Busleitung eingespeisten Adressierungsstrom erfasst. **dadurch gekennzeichnet, dass** jeder adressierbare Busknoten in der Adressierungsphase, dem während der Adressierungsphase noch keine Adresse zugewiesen worden ist, dazu ausgelegt ist in die Busleitung einen jeweiligen Adressierungsstrom einzuspeisen, der zu dem Bus-Master fließt, wobei der jeweilige Adressierungsstrom durch die Stromessschaltung des jeweiligen adressierbaren Busknotens fließt, dem noch keine Adresse zugewiesen worden ist.

## Claims

1. A method for controlling of a serial data bus system
wherein the data bus system is provided with:
a bus line;
a bus master connected to the bus line; and
a plurality of bus nodes serially connected to the bus line; wherein the plurality of bus nodes comprise:
at least two addressable bus nodes receiving addresses in an addressing phase; and
no or at least one standard bus node which has an already fixed address without going through an addressing phase;
wherein the method comprises: the addressing phase for assignment of addresses to at least one of the two addressable bus nodes, and an operating phase for operating the data bus system after termination of the addressing phase;
wherein in the addressing phase, at least two of the plurality of bus nodes feed into the bus line a respective current flowing to the bus master, and
wherein the plurality of bus nodes comprise:
a first bus node connected to the bus line at a site upstream of the bus master and closest to the bus master;
a last bus node connected to the bus line at a site upstream of the bus master and most remote from the bus master; and
no or at least one middle bus node connected to the bus line between the first bus node and the last bus node;
wherein:
each of the at least two addressable bus nodes receives an address assigned by the bus master during the addressing phase and comprises a current measuring circuit connected to the bus line and a controllable bypass switch connected in parallel to said current measuring circuit; and
each of the standard bus nodes, if available, having the respective address that is fixed before performing the addressing phase;
wherein, in said method,
in the addressing phase, an address is assigned to each addressable bus node in an opened state of the bypass switch, and
in the operating phase, the current measuring circuit of each addressed addressable bus node is bypassed by closing the bypass switch;
**characterized in that**,
in said method,
in the addressing phase, each addressable bus node that has not yet been assigned an address during the addressing phase, furthermore feeds into the bus line a respective addressing current flowing to the bus master, wherein the respective addressing current flows through the current measuring circuit of the respective addressable bus node that has not yet been assigned an address.

2. The method according to claim 1, **characterized in that** the addressing phase comprises a plurality of addressing cycles and that for each addressing cycle:
an address is assigned to respectively one of the addressable bus nodes that has not yet been assigned an address; and
after address assigning, the one of the addressable bus nodes does not participate for the remaining addressing phase in a further address assignment for other not-yet-addressed addressable bus nodes, and wherein, after address assigning, the current measuring circuit is bypassed for one of the addressable bus nodes by closing the bypass switch connected in parallel to the current measuring circuit.

3. The method according to claim 1 or 2, **characterized in that** the current measuring circuit comprises a shunt resistor.

4. An addressable bus node for a serial data bus system,
wherein the data bus system comprises:
a bus line;
a bus master connected to the bus line; and
a plurality of bus nodes serially connected to the bus line, wherein the plurality of bus nodes comprise:
at least two addressable bus nodes receiving addresses assigned by the bus master in an addressing phase; and
no or at least one standard bus node, each having an already fixed address without going through an addressing phase;
wherein the addressable bus node comprises:
a current measuring circuit connected to the bus line;
a bypass switch connected in parallel to the current measuring circuit;
an addressing current source for feeding into the bus line an addressing current flowing the bus master; and
a control unit for controlling the bypass switch;
wherein the control unit controls, in an addressing phase of the data bus system provided for assigning an address, the bypass switch to assume an opened state, and wherein the control unit controls, in an operative phase of the data bus system occurring after termination of the addressing phase, the bypass switch to assume a closed state;
wherein the current measuring circuit detects the addressing current fed from the addressing current source into the bus line,
**characterized in that** each addressable bus node in the addressing phase that has not yet been assigned an address during the addressing phase, is adapted to feed into the bus line a respective addressing current flowing to the bus master, wherein the respective addressing current flows through the current measuring circuit of the respective addressable bus node that has not yet been assigned an address.

## Revendications

1. Procédé de commande d'un système de bus de données série,
dans lequel le système de bus de données est prévu doté :
d'une ligne de bus ;
d'un maître bus, lequel est connecté à la ligne de bus ; et
plusieurs nœuds de bus, lesquels sont connectés en série à la ligne de bus ; dans lequel les plusieurs nœuds de bus présentent :
au moins deux nœuds de bus adressables, lesquels reçoivent les adresses dans une phase d'adressage ; et
aucun ou au moins un nœud de bus standard, lequel a une adresse déjà établie sans passer une phase d'adressage ;
dans lequel le procédé comprend : la phase d'adressage afin d'attribuer les adresses à au moins un des deux nœuds de bus adressables, et une phase de fonctionnement pour le fonctionnement du système de bus de données après clôture de la phase d'adressage ;
dans lequel, dans la phase d'adressage, au moins deux des plusieurs nœuds de bus injectent dans la ligne de bus un courant respectif, lequel circule vers le maître bus, et les plusieurs nœuds de bus comportent :
un premier nœud de bus, lequel est connecté à la ligne de bus à une position se trouvant en amont du maître bus et étant la plus rapprochée de celui-ci ;
un dernier nœud de bus, lequel est connecté à la ligne de bus à une position se trouvant en amont du maître bus et étant la plus éloignée de celui-ci ; et
aucun ou au moins un nœud de bus médian, lequel est connecté à la ligne de bus entre le premier nœud de bus et le dernier nœud de bus ;
dans lequel :
chacun des au moins deux nœuds de bus adressables reçoit une adresse attribuée par le maître bus pendant la phase d'adressage et comporte un circuit de mesure de courant, lequel est connecté à la ligne de bus, et un interrupteur de pontage commandable, lequel est commuté en parallèle par rapport au circuit de mesure de courant ; et
chacun des nœuds de bus standard a l'adresse respective, pour autant qu'elle existe, qui a été fixée avant l'exécution de la phase d'adressage ;
dans lequel, dans le procédé :
dans la phase d'adressage, une adresse est attribuée à chaque nœud de bus adressable dans un état ouvert de l'interrupteur de pontage, et dans la phase de fonctionnement le circuit de mesure de courant de chaque nœud de bus adressable adressé est contourné par fermeture de l'interrupteur de pontage ;
**caractérisé en ce qu'**en outre, lors du procédé,
dans la phase d'adressage, chaque nœud de bus adressable auquel aucune adresse n'a encore été attribuée pendant la phase d'adressage injecte dans la ligne de bus un courant respectif, lequel circule vers le maître bus, dans lequel le courant d'adressage respectif circule à travers le circuit de mesure de courant du nœud de bus adressable respectif auquel aucune adresse n'a encore été attribuée.

2. Procédé selon la revendication 1, **caractérisé en ce que** la phase d'adressage comporte plusieurs cycles d'adressage et pour chacun des cycles d'adressage : une adresse est attribuée respectivement à un des nœuds de bus adressables auquel aucune adresse n'a encore été attribuée ; et,
après l'attribution de l'adresse, l'un des nœuds de bus adressables ne participe pas pour le reste de la phase d'adressage à une attribution d'adresse supplémentaire pour d'autres nœuds de bus adressables pas encore adressés, et dans lequel en outre, pour l'un des nœuds de bus adressables le circuit de mesure de courant est contourné, l'interrupteur de pontage commuté en parallèle par rapport au circuit de mesure de courant étant fermé.

3. Procédé selon la revendication 1 ou 2, **caractérisé en ce que** le circuit de mesure de courant comporte une résistance de shunt.

4. Nœud de bus adressable pour un système de bus de données série,
dans lequel le système de bus de données comporte :
une ligne de bus ;
d'un maître bus, lequel est connecté à la ligne de bus ; et
plusieurs nœuds de bus, lesquels sont connectés en série à la ligne de bus, dans lequel les plusieurs nœuds de bus présentent :
au moins deux nœuds de bus adressables, lesquels reçoivent des adresses attribuées par le maître bus dans une phase d'adressage ; et
aucun ou au moins un nœud de bus standard, lequel a une adresse déjà attribuée sans passer une phase d'adressage ;
dans lequel le nœud de bus adressable comporte :
un circuit de mesure de courant, lequel est connecté à la ligne de bus ;
un interrupteur de pontage, lequel est commuté en parallèle par rapport au circuit de mesure de courant ; une source de courant d'adressage afin d'injecter un courant d'adressage dans la ligne de bus, lequel circule vers le maître bus ; et
une unité de commande afin de commander l'interrupteur de pontage ;
dans lequel, dans une phase d'adressage du système de bus de données prévue pour attribuer une adresse, l'unité de commande commande l'interrupteur de pontage afin qu'il occupe un état ouvert et, dans une phase de fonctionnement du système de bus de données s'effectuant après clôture de la phase d'adressage, l'unité de commande commande l'interrupteur de pontage afin qu'il occupe un état fermé ;
dans lequel le circuit de mesure de courant saisit le courant d'adressage injecté dans la ligne de bus par la source de courant d'adressage,
**caractérisé en ce que**, dans la phase d'adressage, chaque nœud de bus adressable auquel aucune adresse n'a encore été attribuée pendant la phase d'adressage est configuré pour injecter dans la ligne de bus un courant respectif, lequel circule vers le maître bus, dans lequel le courant d'adressage respectif circule à travers le circuit de mesure de courant du nœud de bus adressable respectif auquel aucune adresse n'a encore été attribuée.
